# EUROPEAN PATENT APPLICATION

(11) **EP 1 790 622 A1**
(43) Date of publication of application: **30.05.2007**
(21) Application number: 06024716.0
(22) Date of filing: 29.11.2006
(51) Int. Cl.: C04B 35/493

(54) **Complex metal oxide raw material composition**

(30) Priority: 29.11.2005 JP 2005344700
(71) Applicant: SEIKO EPSON CORPORATION, Shinjuku-ku Tokyo 163-0811 (JP)
(72) Inventor: Kijima, Takeshi c/o SEIKO EPSON CORPORATION, Suwa-shi, Nagano-ken 392-8502 (JP); Hamada, Yasuaki c/o SEIKO EPSON CORPORATION, Suwa-shi, Nagano-ken 392-8502 (JP); Ueno, Mayumi c/o SEIKO EPSON CORPORATION, Suwa-shi, Nagano-ken 392-8502 (JP)
(74) Representative: Hoffmann, Eckart

(57) **Abstract**

A complex metal oxide raw material composition used for forming a complex metal oxide, the complex metal oxide being shown by a general formula AB₁₋ₓCₓO₃, wherein an element A includes at least Pb, an element B includes at least one of Zr, Ti, V, W, and Hf, and an element C includes at least one of Nb and Ta, and the raw material composition including: at least one of a thermally-decomposable organometallic compound including the element A, the element B, or the element C, a hydrolyzable organometallic compound including the element A, the element B, or the element C, and a partial hydrolyzate and/or a polycondensate of the hydrolyzable organometallic compound; at least one of a polycarboxylic acid and a polycarboxylic acid ester; and an organic solvent.

## Description

### BACKGROUND OF THE INVENTION

The present invention relates to a complex metal oxide raw material composition for forming a complex metal oxide.

A complex metal oxide such as PZT has been used for various applications such as a ferroelectric memory, a piezoelectric device, an infrared sensor, and a surface acoustic wave (SAW) device, and has been extensively researched and developed.

As a typical method of forming a complex metal oxide, a chemical solution deposition (CSD) method such as a sol-gel method or a metalorganic deposition (MOD) method has been known.

The sol-gel method utilizes a solution of a precursor prepared by polymerizing a compound such as a metal alkoxide by hydrolysis and polycondensation (hereinafter may be called "hydrolysis-condensation"). The sol-gel method has an advantage in that a complex metal oxide is obtained with excellent composition controllability by controlling the composition of a metal alkoxide solution. On the other hand, since a hydrolysis-condensation reaction is an irreversible reaction, a metal alkoxide which has been crosslinked and polymerized cannot be used as the sol-gel raw material. In particular, when forming a lead-containing complex metal oxide such as PZT, it is necessary to process lead waste.

The MOD method utilizes a solution of a stable organometallic compound such as a metal carboxylate. Since the raw material solution used in the MOD method contains a stable organometallic compound as the raw material, it is easy to adjust the solution composition and to handle the raw material solution. On the other hand, since the MOD method forms a complex oxide by decomposing an organic group with a high molecular weight in an oxygen atmosphere, differing from the sol-gel method which forms a complex oxide by hydrolysis and polycondensation of a compound, the crystallization temperature is increased in comparison with the sol-gel method, whereby the crystal grain size tends to be increased.

### SUMMARY

According to one aspect of the invention, there is provided a complex metal oxide raw material composition used for forming a complex metal oxide,
the complex metal oxide being shown by a general formula AB₁₋ₓCₓO₃, wherein an element A includes at least Pb, an element B includes at least one of Zr, Ti, V, W, and Hf, and an element C includes at least one of Nb and Ta, and
the raw material composition including:
at least one of a thermally-decomposable organometallic compound including the element A, the element B, or the element C, a hydrolyzable organometallic compound including the element A, the element B, or the element C, and a partial hydrolyzate and/or a polycondensate of the hydrolyzable organometallic compound;
at least one of a polycarboxylic acid and a polycarboxylic acid ester; and
an organic solvent.

### BRIEF DESCRIPTION OF THE SEVERAL VIEWS OF THE DRAWING

FIG. 1 shows a change in Raman vibration mode of an A-site ion when adding Si to lead titanate in one embodiment of the invention.
FIG. 2 shows lead-containing carboxylic acids used in one embodiment of the invention.
FIGS. 3A to 3D are views showing polycarboxylic acids or polycarboxylic acid esters used in one embodiment of the invention.
FIG. 4 shows the crystallinity of a sample of Example 1 according to one embodiment of the invention determined by X-ray diffraction analysis.
FIGS. 5A to 5C show the hysteresis characteristics of a sample of Example 1 according to one embodiment of the invention.
FIG. 6 shows the polarization characteristics of a sample of Example 1 according to one embodiment of the invention.
FIG 7 shows the FT-IR spectrum of a sample of Example 1 according to one embodiment of the invention.
FIG. 8 shows the differential FT-IR spectrum of a sample of Example 1 according to one embodiment of the invention.
FIG 9 shows the crystallinity of a sample of Example 2 according to one embodiment of the invention determined by X-ray diffraction analysis.
FIGS. 10A and 10B show the hysteresis characteristics of a sample of Example 2 according to one embodiment of the invention.
FIGS. 11A to 11C show the surface morphology of a PZTN film of Example 3 according to one embodiment of the invention.
FIGS. 12A to 12C show the crystallinity of a PZTN film of Example 3 according to one embodiment of the invention.
FIGS. 13A to 13C show the relationship between the thickness and the surface morphology of a PZTN film of Example 3 according to one embodiment of the invention.
FIGS. 14A to 14C show the relationship between the thickness and the crystallinity of a PZTN film of Example 3 according to one embodiment of the invention.
FIGS. 15A to 15C show the thickness and the hysteresis characteristics of a PZTN film of Example 3 according to one embodiment of the invention.
FIGS. 16A to 16C show the thickness and the hysteresis characteristics of a PZTN film of Example 3 according to one embodiment of the invention.
FIGS. 17A and 17B show the leakage current characteristics of a PZTN film of Example 3 according to one embodiment of the invention.
FIGS. 18A and 18B show the fatigue characteristics and the static imprint characteristics of a PZTN film of Example 3 according to one embodiment of the invention.
FIG. 19 shows a capacitor structure in which an SiO₂ protective film is formed by ozone TEOS in Example 3 according to one embodiment of the invention.
FIG 20 shows the hysteresis characteristics of a capacitor structure in which an SiO₂ protective film is formed by ozone TEOS in Example 3 according to one embodiment of the invention.
FIG. 21 shows the leakage current characteristics of a known PZT film of Example 3 according to one embodiment of the invention.
FIG. 22 shows the fatigue characteristics of a known PZT film of Example 3 according to one embodiment of the invention.
FIG. 23 shows the static imprint characteristics of a known PZT film of Example 3 according to one embodiment of the invention.
FIGS. 24A and 24B show the hysteresis characteristics of a PZTN film of Example 4 according to one embodiment of the invention.
FIGS. 25A and 25B show the hysteresis characteristics of a PZTN film of Example 4 according to one embodiment of the invention.
FIGS. 26A and 26B show the hysteresis characteristics of a PZTN film of Example 4 according to one embodiment of the invention.
FIG 27 shows the X-ray diffraction pattern of a PZTN film of Example 4 according to one embodiment of the invention.
FIG. 28 shows the relationship between the Pb deficiency and the Nb composition ratio in a PZTN crystal of Example 4 according to one embodiment of the invention.
FIG 29 is a view illustrative of the crystal structure of WO₃ (perovskite crystal).
FIG. 30 shows the X-ray diffraction pattern of a sample according to a comparative example of one embodiment of the invention.
FIG 31 shows a method of forming a sample of Example 1 according to one embodiment of the invention.
FIG. 32 shows the differential thermal analysis results of a sample of Example 2 according to one embodiment of the invention.
FIG. 33 shows the X-ray diffraction pattern of a PZTN film of Example 5 according to one embodiment of the invention.
FIG. 34 shows the hysteresis characteristics of a PZTN film of Example 5 according to one embodiment of the invention.
FIG. 35 shows the X-ray diffraction pattern of a PZTN film of Example 5 according to one embodiment of the invention.
FIG. 36 shows the hysteresis characteristics of a PZTN film of Example 5 according to one embodiment of the invention.
FIG. 37 shows the X-ray diffraction pattern of a PZTN film of Example 5 according to one embodiment of the invention.
FIG 38 shows the hysteresis characteristics of a PZTN film of Example 5 according to one embodiment of the invention.
FIG. 39 shows the hysteresis characteristics of a PZTT film of Example 6 according to one embodiment of the invention.
FIG. 40 shows the X-ray diffraction patterns of a PZTN film of Example 7 and
Reference Example according to one embodiment of the invention. FIG 41 is a partially enlarged view of FIG. 40.
FIG. 42 shows the surface morphology of a PZTN film of Example 2 according to one embodiment of the invention.
FIG. 43 shows the X-ray diffraction pattern of a PZTN film of Example 8 according to one embodiment of the invention.
FIGS. 44A and 44B show the hysteresis characteristics of a PZTN film of Example 8 according to one embodiment of the invention.
FIG 45 shows the surface morphology of a PZTN film of Example 8 according to one embodiment of the invention.
FIG. 46 shows the X-ray diffraction pattern of a PZTN film of Example 9 according to one embodiment of the invention.
FIGS. 47A to 47D show the hysteresis characteristics of a PZTN film of Example 9 according to one embodiment of the invention.
FIGS. 48A to 48D show the surface morphology of a PZTN film of Example 9 according to one embodiment of the invention.
FIG. 49 shows the NMR analysis results of a specific raw material composition.
FIG 50 shows the NMR analysis results of a raw material composition according to an example of the invention.
FIG. 51 shows the IR analysis results of a raw material composition according to an example of the invention.
FIG. 52 shows the reaction mechanism of a raw material composition according to the invention.
FIG. 53 shows the reaction mechanism of a raw material composition according to the invention.
FIGS 54A to 54C schematically show crystallization of a coating film using a raw material composition according to the invention.

### DETAILED DESCRIPTION OF THE EMBODIMENT

The invention may provide a raw material composition for forming a complex metal oxide with excellent composition controllability using a liquid phase method.

According to one embodiment of the invention, there is provided a complex metal oxide raw material composition used for forming a complex metal oxide,
the complex metal oxide being shown by a general formula AB₁₋ₓCₓO₃, wherein an element A includes at least Pb, an element B includes at least one of Zr, Ti, V, W, and Hf, and an element C includes at least one of Nb and Ta, and
the raw material composition including:
at least one of a thermally-decomposable organometallic compound including the element A, the element B, or the element C, a hydrolyzable organometallic compound including the element A, the element B, or the element C, and a partial hydrolyzate and/or a polycondensate of the hydrolyzable organometallic compound;
at least one of a polycarboxylic acid and a polycarboxylic acid ester; and
an organic solvent.

In this complex metal oxide raw material composition, the element B may include Zr and Ti; and the element C may include Nb.

In this complex metal oxide raw material composition, the organic solvent may be an alcohol.

In this complex metal oxide raw material composition, the complex metal oxide may include Nb in a range of 0.05≤x≤1.

In this complex metal oxide raw material composition, the complex metal oxide may include Nb in a range of 0.1≤x≤0.3.

In this complex metal oxide raw material composition, the complex metal oxide may include Ta in a range of 0.05≤x<1.

In this complex metal oxide raw material composition, the complex metal oxide may include 0.5 mol% or more of Si or Si and Ge.

In this complex metal oxide raw material composition, the complex metal oxide may include 0.5 to 5 mol% of Si or Si and Ge.

In this complex metal oxide raw material composition, the polycarboxylic acid or the polycarboxylic acid ester may be a dicarboxylic acid or a dicarboxylic acid ester.

In this complex metal oxide raw material composition, the organometallic compound including the element A may be a lead carboxylate.

In this complex metal oxide raw material composition, the organometallic compound including the element B may be a niobium carboxylate.

In this complex metal oxide raw material composition, the polycarboxylic acid or the polycarboxylic acid ester may have a boiling point higher than the boiling point of the organic solvent.

Some embodiments of the invention will be described in detail below, with reference to the drawings.

### 1. Complex metal oxide raw material composition

A complex metal oxide raw material composition (hereinafter called "raw material composition") according to this embodiment is used to form a complex metal oxide film. The complex metal oxide may be shown by the general formula AB₁₋ₓCₓO_{3.} The element A may include at least Pb, the element B may include at least one of Zr, Ti, V, W, and Hf, and the element C may include at least one of Nb and Ta.

The raw material composition includes at least one of a thermally-decomposable organometallic compound including the element A, the element B, or the element C, a hydrolyzable organometallic compound including the element A, the element B, or the element C, and a partial hydrolyzate and/or a polycondensate thereof, at least one of a polycarboxylic acid and a polycarboxylic acid ester, and an organic solvent.

The raw material composition may be prepared by mixing organometallic compounds respectively including the constituent metal of the material for the complex metal oxide or a partial hydrolyzate and/or a polycondensate thereof so that the metals are contained at a desired molar ratio, and dissolving or dispersing the components using an organic solvent such as an alcohol. It is preferable to use an organometallic compound which is stable in a solution state.

As the organometallic compound which may be used in this embodiment, an organometallic compound which can produce a metal oxide originating in the organometallic compound by hydrolysis or oxidation can be given. The organometallic compound is selected from the alkoxide of each metal, an organometallic complex, an organic acid salt, and the like.

As the thermally-decomposable organometallic compound including the constituent metal of the complex metal oxide, an organometallic compound such as a metal alkoxide, an organic acid salt, or a beta-diketone complex may be used. As the hydrolyzable organometallic compound including the constituent metal of the complex metal oxide, an organometallic compound such as a metal alkoxide may be used. Examples of the organometallic compound are given below.

As examples of the organometallic compound including Zr, Ti, V, W, or Hf (element B), an alkoxide, acetate, octylate, and the like of these elements can be given.

As examples of the organometallic compound including Pb (element A), lead acetate and lead octylate can be given.

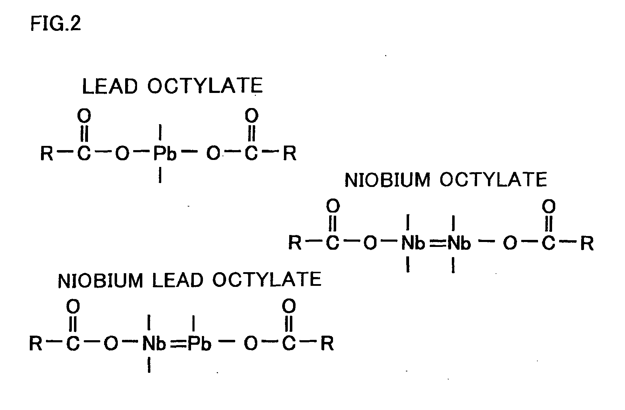

As examples of the organometallic compound including Nb (element C), niobium octylate and lead octylate niobate can be given. As shown in FIG 2, niobium octylate has a structure in which two Nb atoms form a covalent bond and an octyl group exists in the remaining site. As an example of the organometallic compound including Ta (element C), tantalum octylate can be given.

In the raw material composition according to this embodiment, an alcohol may be used as the organic solvent. The organometallic compound and the polycarboxylic acid or the polycarboxylic acid ester can be efficiently dissolved by using the alcohol as the solvent. The alcohol is not particularly limited. As examples of the alcohol, monohydric alcohols such as butanol, methanol, ethanol, and propanol, and polyhydric alcohols can be given. Specific examples of the alcohol are given below.

### Monohydric alcohol:

Propanol (propyl alcohol): 1-propanol (boiling point: 97.4°C) and 2-propanol (boiling point: 82.7°C)
Butanol (butyl alcohol): 1-butanol (boiling point: 117°C), 2-butanol (boiling point: 100°C), 2-methyl-1-propanol (boiling point: 108°C), and 2-methyl-2-propanol (melting point: 25.4°C, boiling point: 83°C)
Pentanol (amyl alcohol): 1-pentanol (boiling point: 137°C), 3-methyl-1-butanol (boiling point: 131°C), 2-methyl-1-butanol (boiling point: 128°C), 2,2-dimethyl-1-propanol (boiling point: 113°C), 2-pentanol (boiling point: 119°C), 3-methyl-2-butanol (boiling point: 112.5°C), 3-pentanol (boiling point: 117°C), and 2-methyl-2-butanol (boiling point: 102°C)

### Polyhydric alcohol:

Ethylene glycol (melting point: -11.5°C, boiling point: 197.5°C) and glycerol (melting point: 17°C, boiling point: 290°C)

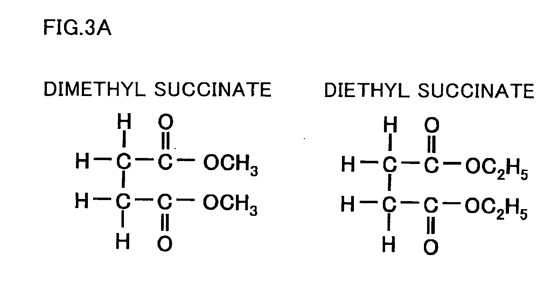

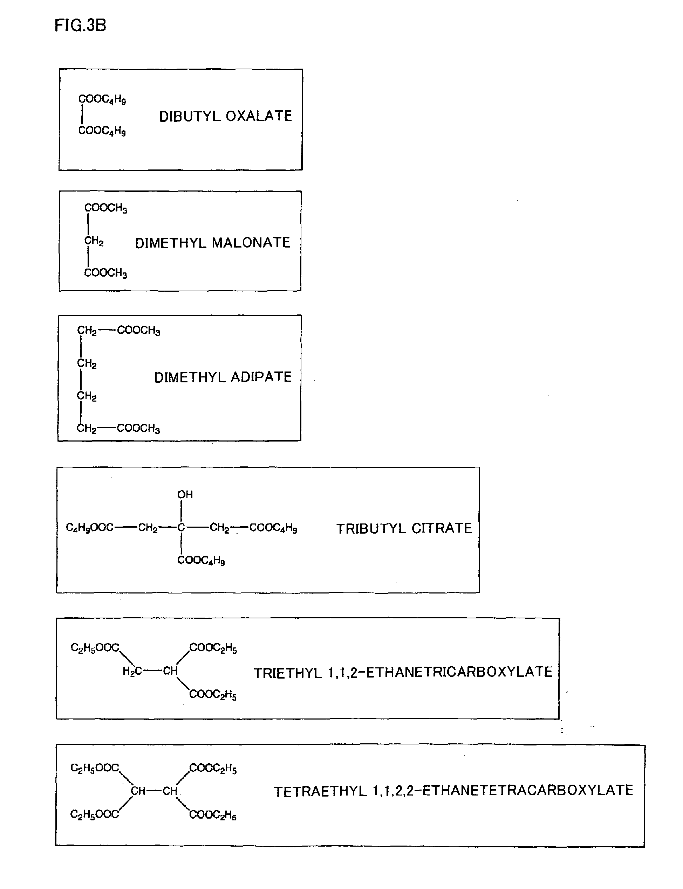

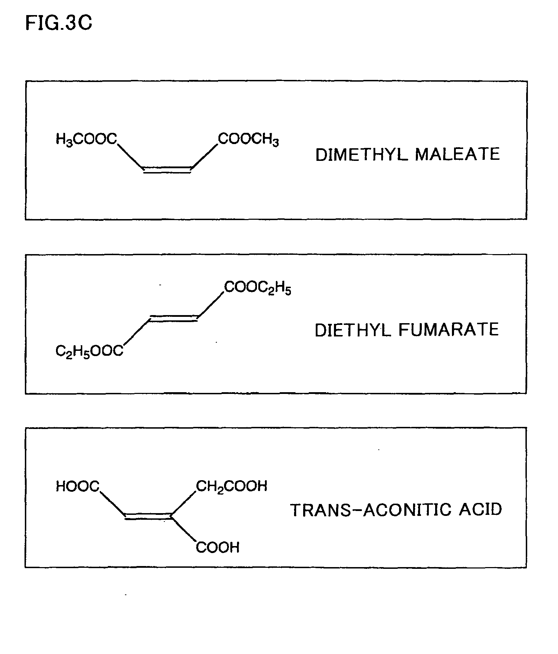

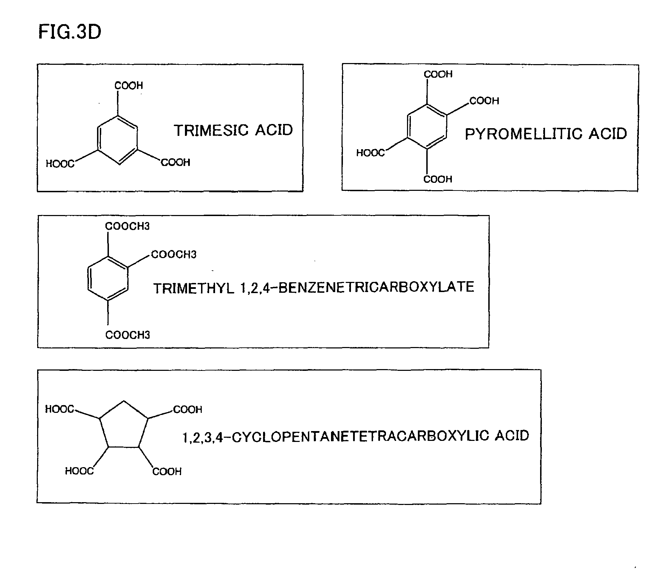

In the raw material composition according to the invention, the polycarboxylic acid or the polycarboxylic acid ester may be a carboxylic acid or a carboxylic acid ester having two or more carboxyl groups. As examples of the polycarboxylic acid used in the invention, the following compounds can be given. As examples of a tricarboxylic acid, trans-aconitic acid, trimesic acid, and the like can be given. As examples of a tetracarboxylic acid, pyromellitic acid, 1,2,3,4-cyclopentanetetracarboxylic acid, and the like can be given. As examples of the polycarboxylic acid ester, dicarboxylic acid esters such as dimethyl succinate, diethyl succinate, dibutyl oxalate, dimethyl malonate, dimethyl adipate, dimethyl maleate, and diethyl fumarate, tricarboxylic acid esters such as tributyl citrate and triethyl 1,1,2-ethanetricarboxylate, tetracarboxylic acid esters such as tetraethyl 1,1,2,2-ethanetetracarboxylate and trimethyl 1,2,4-benzenetricarboxylate, and the like can be given. FIGS. 3B to 3D show examples of the polycarboxylic acids or the polycarboxylic acid esters.

In the raw material composition according to the invention, the dicarboxylic acid ester may be preferably at least one compound selected from a succinic acid ester, a maleic acid ester, and a malonic acid ester. As specific examples of these esters, dimethyl succinate, dimethyl maleate, and dimethyl malonate can be given.

The polycarboxylic acid or the polycarboxylic acid ester may have a boiling point higher than that of the organic solvent. If the polycarboxylic acid or the polycarboxylic acid ester has a boiling point higher than that of the organic solvent, the reaction of the raw material composition can occur more promptly, as described later.

The polycarboxylic acid ester may have a molecular weight of 150 or less. If the molecular weight of the polycarboxylic acid ester is too high, the resulting film may be damaged when the ester volatilizes during heat treatment, whereby a dense film may not be obtained.

The polycarboxylic acid ester may be liquid at room temperature. If the polycarboxylic acid ester is solid at room temperature, gelation may occur.

A complex metal oxide obtained by using the raw material composition according to this embodiment may include Nb in the range of preferably 0.05≤x<1, and still more preferably 0.1≤x≤0.3. The complex metal oxide may include Si or Si and Ge in an amount of preferably 0.5 mol% or more, and still more preferably 0.5 mol% or more and 5 mol% or less. The element B may be Zr and Ti. Specifically, the complex metal oxide according to this embodiment may be Pb(Zr,Ti,Nb)O₃ (PZTN) in which the Ti site is doped with Nb.

Nb has a size approximately equal to that of Ti (i.e. Nb and Ti have similar ionic radii and have the same atomic radius) and has an atomic weight twice the atomic weight of Ti. Therefore, Nb is not easily released from a lattice even if a collision occurs between atoms due to lattice vibration. Since Nb is stable at a valence of +5, the valence of Pb can be compensated for by Nb⁵⁺ even if Pb is released. Moreover, even if Pb is released during crystallization, it is easier for Nb with a small size to enter the lattice than for O with a large size to be released.

Since Nb⁴⁺ also exists, Nb can replace Ti⁴⁺. In addition, it is considered that Nb is not easily released due to very strong covalent bonding properties (H. Miyazawa, E. Natori, S. Miyashita; Jpn. J. Appl. Phys. 39 (2000) 5679).

Since the complex metal oxide (particularly PZTN) obtained by using the raw material composition according to this embodiment includes a specific amount of Nb, the complex metal oxide exhibits excellent composition controllability due to the absence of adverse effects caused by Pb deficiency. As a result, the PZTN exhibits excellent hysteresis characteristics, leakage characteristics, reduction resistance, piezoelectricity, and insulating properties in comparison with PZT, as is clear from the examples described later.

Nb has been doped into PZT mainly in the Zr-rich rhombohedral region. However, the amount of doping is as small as about 0.2 to 0.025 mol% (J. Am. Ceram. Soc, 84 (2001) 902; Phys. Rev. Let, 83 (1999) 1347). This is because the crystallization temperature is increased when adding a large amount of Nb (e.g. the crystallization temperature is increased to 800°C or more when adding Nb in an amount of 10 mol%).

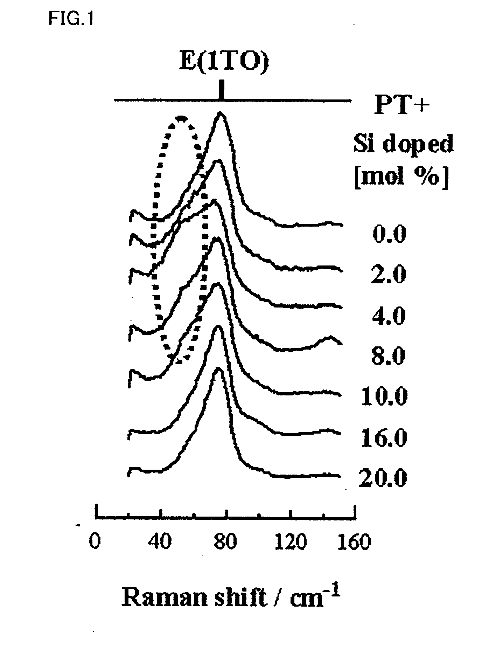

According to this embodiment, the crystallization energy of PZTN can be reduced by incorporating Si or Si and Ge in the complex metal oxide in an amount of 0.5 to 5 mol%, for example. Specifically, when using PZTN as the material for the complex metal oxide, the crystallization temperature of PZTN can be reduced by adding Si or Si and Ge in addition to Nb. The inventors of the invention have confirmed that Si functions as a sintering agent and then forms part of the crystal as the A-site ion (see FIG 1). Specifically, when adding Si to lead titanate, a change occurred in the Raman vibration mode E (1T0) of the A-site ion, as shown in FIG 1. The change in the Raman vibration mode was observed when adding Si in an amount of 8 mol% or less. Therefore, it was confirmed that Si exists in the A site of the perovskite when adding a specific amount of Si.

In the invention, Ta may be used instead of Nb, or may be used together with Nb. Ta shows a tendency similar to that of Nb.

The amount of the polycarboxylic acid or the polycarboxylic acid ester used varies depending on the composition of the complex metal oxide. For example, the total molar ionic concentration of the metals for forming the complex metal oxide and the molar ionic concentration of the polycarboxylic acid (ester) may be preferably set at 1 ≥ (molar ionic concentration of polycarboxylic acid (ester)) / (total molar ionic concentration of metals in raw material solution).

The number of moles of the polycarboxylic acid or the polycarboxylic acid ester used herein refers to the number of carboxyl groups. Specifically, when using a dicarboxylic acid or a dicarboxylic acid ester, the ratio is 1:1 when the amount of dicarboxylic acid or dicarboxylic acid ester is 0.5 mol for 1 mol of metals in the raw material solution.

### 2. Method of producing complex metal oxide film

A complex metal oxide film is obtained by applying the above-described raw material composition according to this embodiment to a substrate, and heating the applied composition.

In more detail, the raw material composition is applied to a substrate by spin coating or the like, and dried at 150 to 180°C using a hot plate or the like to remove the solvent. A cleaning heat treatment (which mainly decomposes and removes organic components) is then performed at 300 to 350°C using a hot plate or the like. The coating step, the drying step, and the cleaning heat treatment step are optionally performed a number of times to obtain a coating film with a desired thickness. The coating film is then subjected to crystallization annealing (sintering) to form a complex metal oxide film with a desired thickness. The crystallization sintering may be performed at 650 to 700°C in an oxygen atmosphere by rapid thermal annealing (RTA) or the like.

The substrate is selected depending on the application of the complex metal oxide. An insulating substrate, a conductive substrate, a semiconductor substrate, or the like may be used. According to this production method, a complex metal oxide film having excellent characteristics can be obtained by a simple method using a known coating method.

### 3. Examples

Examples according to the invention are described below.

### Example 1

In this example, a PZTN complex metal oxide raw material composition was prepared. A solution prepared by dissolving organometallic compounds of Pb, Zr, Ti, and Nb in n-butanol was used. Specifically, lead acetate, zirconium alkoxide, titanium alkoxide, and niobium octylate were used. These organometallic compounds, dimethyl succinate (polycarboxylic acid ester), and n-butanol (organic solvent) were mixed.

In this example, the organometallic compounds were mixed at a PbZr_{0.2}Ti_{0.6}Nb_{0.2}O₃ (PZTN) composition. In order to reduce the crystallization temperature of the complex metal oxide film, silicon alkoxide was added to the raw material composition in an amount of 3 mol%. The raw material composition was prepared by dissolving the organometallic compounds and dimethyl succinate in n-butanol at a ratio (molar ratio) of 1:1.

A sample was obtained as follows.

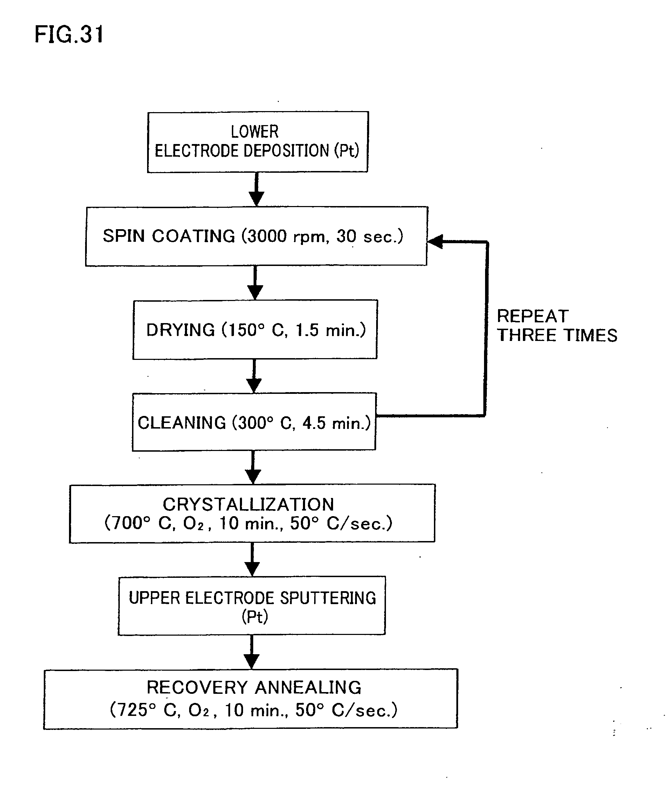

The raw material composition was stored at room temperature for eight weeks in a state in which the container was open. A sample was prepared according the method shown in FIG 31 using the solution allowed to stand for a specific period. Specifically, the solution was applied by spin coating to a platinum substrate (substrate in which a silicon oxide layer, a titanium oxide layer, and a platinum layer were formed on a silicon substrate), and dried at 150 to 180°C (150°C) using a hot plate to remove the alcohol. A cleaning heat treatment was then performed at 300 to 350°C (300°C) using a hot plate. The coating step, the drying step, and the cleaning heat treatment step were optionally performed a number of times to obtain a coating film with a desired thickness. The coating film was then subjected to crystallization annealing (sintering) to obtain a complex metal oxide film sample with a thickness of 150 nm. The crystallization sintering was performed at 650 to 700°C (700°C) in an oxygen atmosphere by rapid thermal annealing (RTA). A platinum upper electrode was then formed by sputtering to obtain a complex metal oxide capacitor sample (hereinafter may be called "capacitor sample").

The following characteristics were examined using the resulting samples.

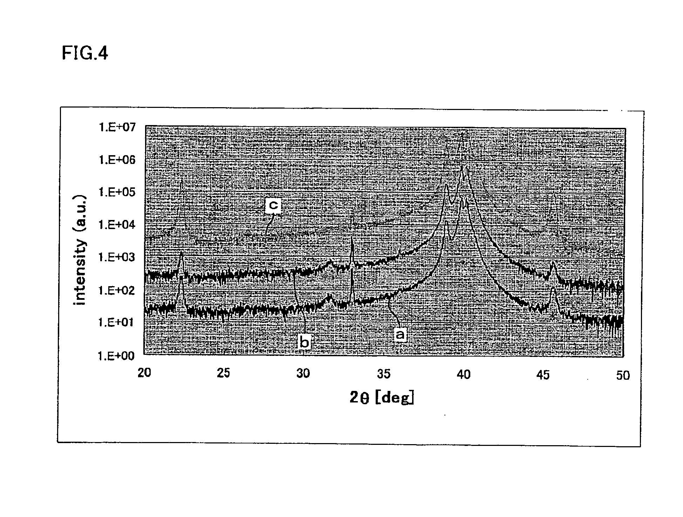

The crystallinity of three complex metal oxide film samples was examined by X-ray diffraction analysis. The results are shown in FIG 4. In FIG. 4, the graph indicated by the symbol a shows the results of the sample a using the solution immediately after preparation, the graph indicated by the symbol b shows the results of the sample b using the solution allowed to stand for three weeks after preparation in a state in which the container was open, and the graph indicated by the symbol c shows the results of the sample c using the solution allowed to stand for eight weeks after preparation in a state in which the container was open.

As shown in FIG 4, PZTN (100) and (111) peaks were observed for each sample.

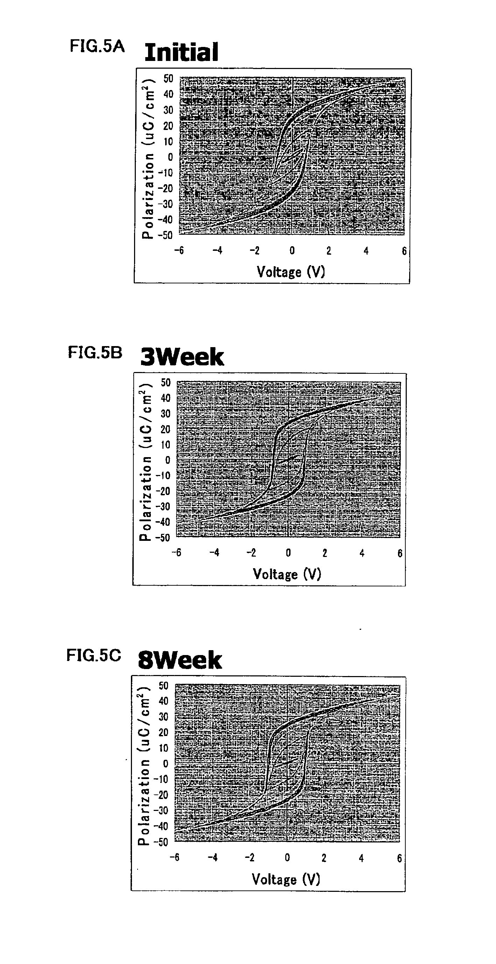

FIGS. 5A to 5C show the hysteresis characteristics of the capacitor samples a, b, and c including the complex metal oxide film samples a, b, and c, respectively. As shown in FIGS. 5A to 5C, it was confirmed that the capacitor samples b and c exhibited excellent hysteresis characteristics in comparison with the capacitor sample a.

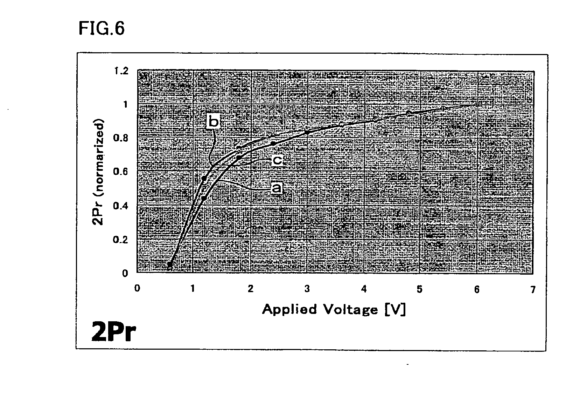

FIG. 6 shows the polarization characteristics determined for the capacitor samples a, b, and c. As shown in FIG. 6, it was confirmed that the capacitor samples a, b, and c exhibited excellent polarization characteristics.

Complex metal oxide film samples were respectively formed using the solutions (raw material composition) allowed to stand for four days, seven days, 11 days, two weeks, three weeks, eight weeks, and 12 weeks after preparation in a state in which the container was open. The sample was formed by applying the solution to a platinum substrate and removing the organic solvent (n-butanol) from the coating film at room temperature by blowing nitrogen gas. These samples are referred to as samples b, c, d, e, f, g, and h.

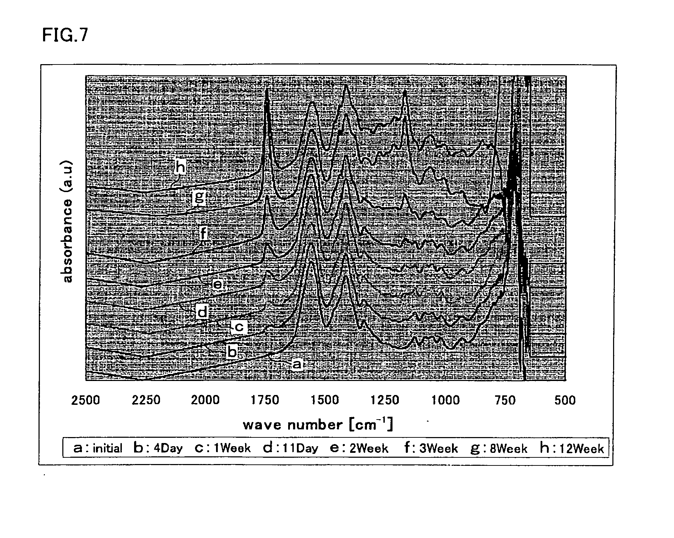

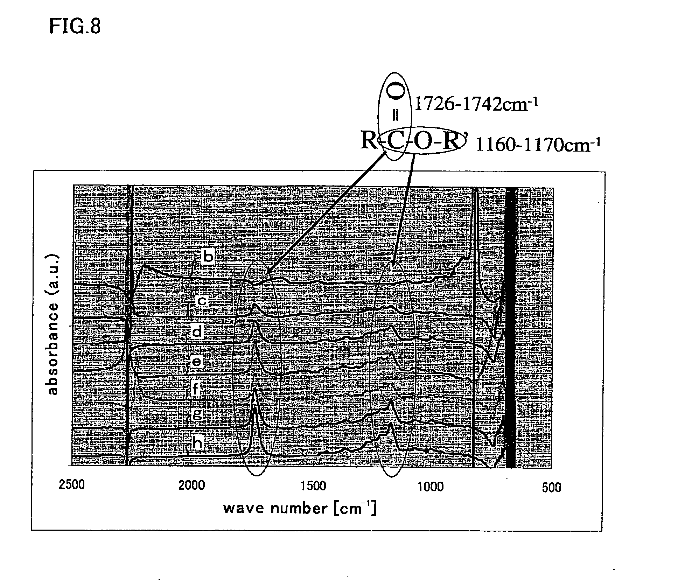

FIGS. 7 and 8 show the Fourier transform infrared spectroscopy (FT-IR) results of the samples a to h. FIG. 7 also shows the results of the capacitor sample a. FIG 8 shows the difference (differential spectrum) between the spectrum of each of the samples b to h and the spectrum of the sample a determined from the spectra shown in FIG 7. The peak at a wavelength of 1160 to 1170 cm⁻¹ indicates C-O-R', and the peak at a wavelength of 1726 to 1742 cm⁻¹ indicates a carbonyl group (C=O). As shown in FIGS. 7 and 8, it was confirmed that the peaks indicating ester bonds become larger as the time elapsed from the preparation of the solution increases due to evaporation of n-butanol (solvent), indicating that molecules having an ester bond were formed in the solution.

### Example 2

This example differs from Example 1 in that the solution was heated during preparation. The composition of the solution was the same as in Example 1. Specifically, silicon alkoxide was added to the PbZr_{0.2}Ti_{0.8}Nb_{0.2}O₃ (PZTN) solution used in Example 1 in an amount of 2 mol% to obtain a raw material composition. The raw material composition was heated at 80°C for 60 minutes.

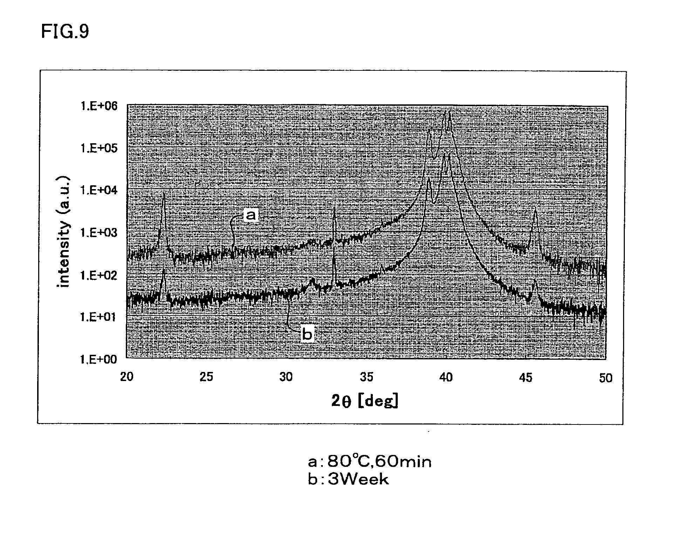

A sample 1 of this example was obtained as follows. The solution (raw material composition) was applied to a platinum substrate by spin coating, and dried at 150 to 180°C using a hot plate to remove the alcohol. A cleaning heat treatment was then performed at 300 to 350°C using a hot plate. The coating step, the drying step, and the cleaning heat treatment step were optionally performed a number of times to obtain a coating film with a desired thickness. The coating film was then subjected to crystallization annealing (sintering) to obtain a complex metal oxide film with a thickness of 150 nm. The crystallization sintering was performed at 700°C in an oxygen atmosphere by rapid thermal annealing (RTA). The complex metal oxide film sample 1 was thus obtained. The crystallinity of the sample 1 was examined by X-ray diffraction analysis. The results are shown in FIG 9. In FIG 9, the graph indicated by the symbol a shows the results of the sample b of Example 1 using the solution allowed to stand for three weeks after preparation, and the graph indicated by the symbol b shows the results of the sample 1 of this example.

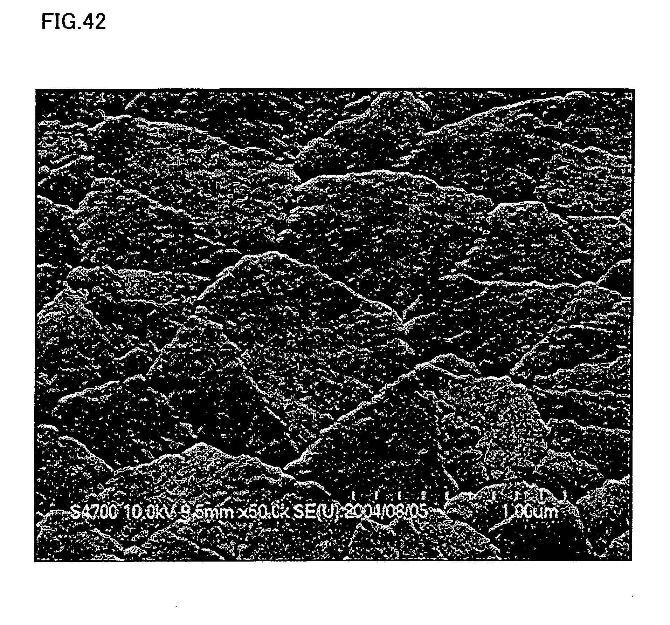

As shown in FIG 9, it was confirmed that the sample 1 of this example exhibited crystallinity equal to or better than that of the sample b of Example 1. The surface morphology of the complex metal oxide film sample 1 was examined by SEM. As shown in FIG 42, the sample 1 exhibited excellent surface morphology.

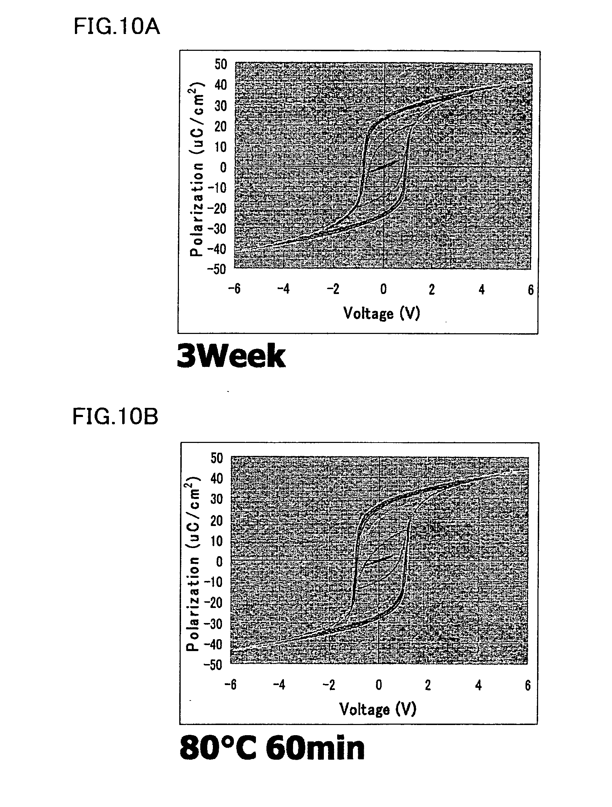

FIGS. 10A and 10B show the hysteresis characteristics of the samples differing in solution preparation conditions. FIG. 10A shows the results of the sample b of Example 1 using the solution allowed to stand at room temperature for three weeks after preparation, and FIG 10B shows the results of the sample 1 of this example. As shown in FIG 10, it was confirmed that these samples exhibited excellent hysteresis characteristics.

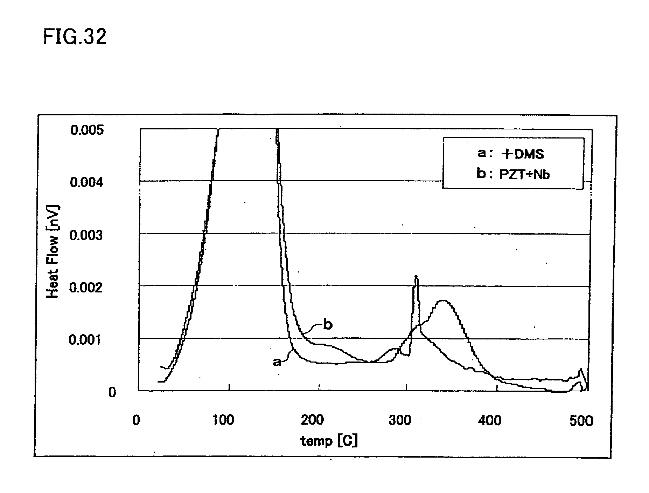

FIG. 32 shows the solution decomposition process determined for the sample 1 of this example and a sample of Comparative Example 1 by differential thermal analysis. In FIG 32, the graph indicated by the symbol a shows the results of the sample 1 of this example, and the graph indicated by the symbol b shows the results of the sample of Comparative Example 1. In Comparative Example 1, niobium octylate was added to a commercially available PZT sol-gel raw material so that the composition was the same as the composition of this example.

As shown in FIG 32, it was confirmed that the sample 1 of this example had a sharp peak at about 300°C. This suggests that the amorphous components (polycondensate including lead acetate, niobium octylate, Zr, Ti, and Si) in the raw material solution of this example were entirely thermally decomposed and oxidized at the same time after application. On the other hand, the sample of Comparative Example 1 showed a broad peak and nonuniform organic chain decomposition energy. This indicates that the chemical structure of the precursor was not uniform.

### Example 3

This example compares PZTN obtained according to the invention with known PZT. A raw material composition was prepared in the same manner as in Example 2. The composition of the raw material composition was as follows.

The ratio of Pb:Zr:Ti:Nb was 1:0.2:0.6:0.2. Si was added to the raw material composition in an amount of 0 mol%, 0.5 mol%, or 1 mol%.

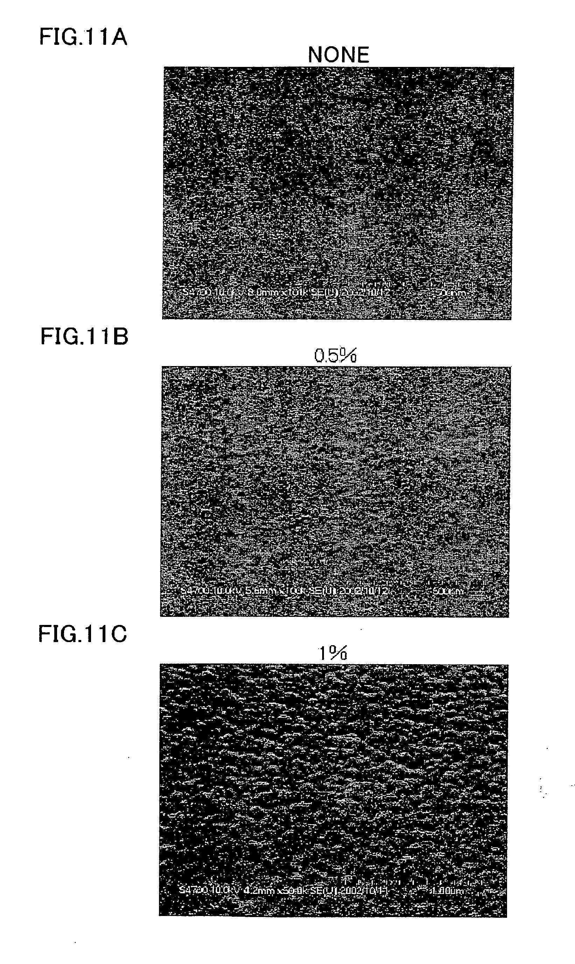

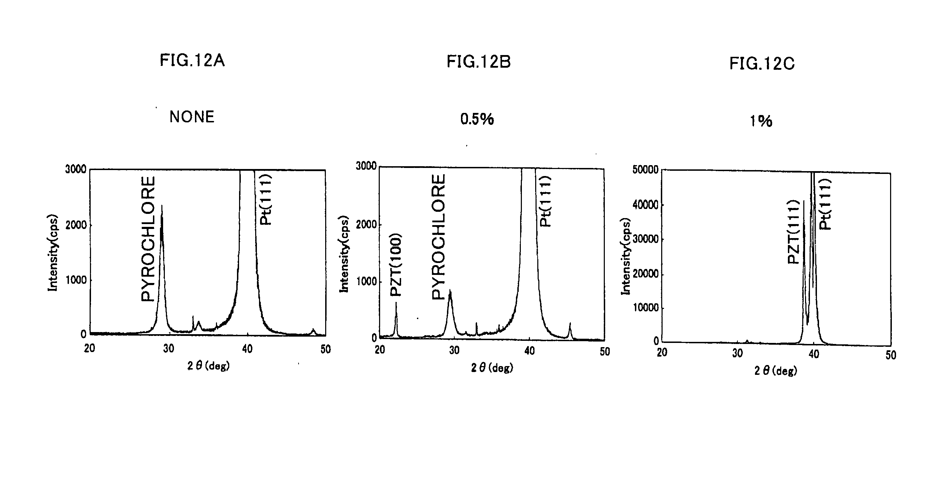

FIGS. 11A to 11C show the surface morphology of the resulting films. FIGS. 12A to 12C show the crystallinity of the films measured using an X-ray diffraction method. When the amount of silicate was 0 mol% (none) (FIG. 12A), only a paraelectric pyrochlore was obtained even if the crystallization temperature was increased to 800°C. When the amount of silicate was 0.5 mol% (FIG 12B), PZT and a pyrochlore were mixed. When the amount of silicate was 1 mol% (FIG. 12C), a PZT (111)-oriented film was obtained. The film showed a crystallinity as excellent as ever.

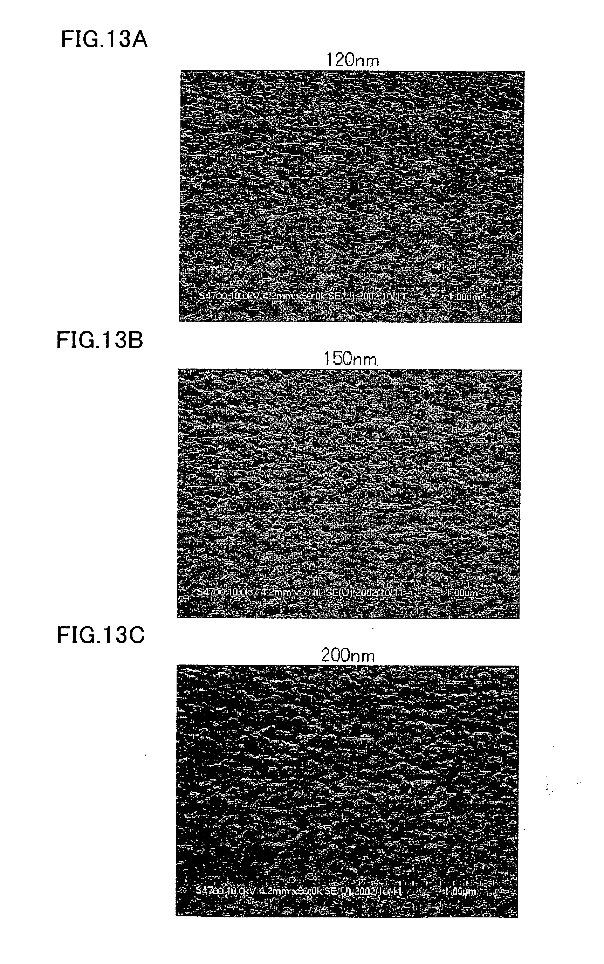

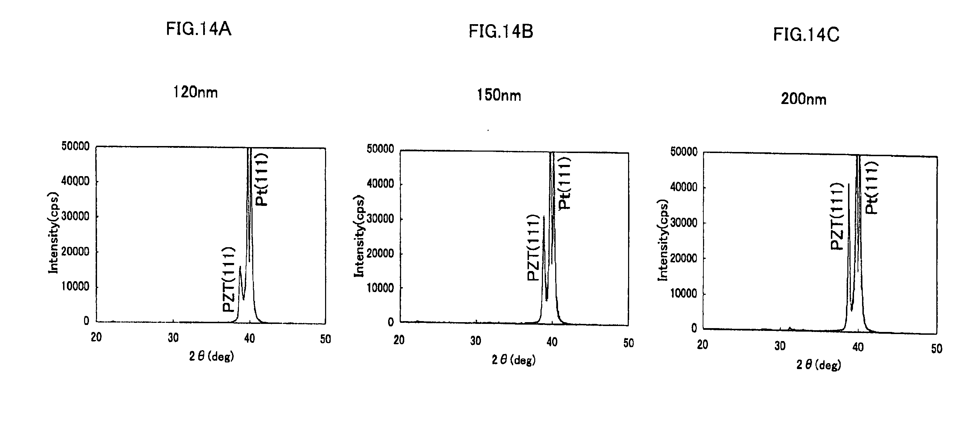

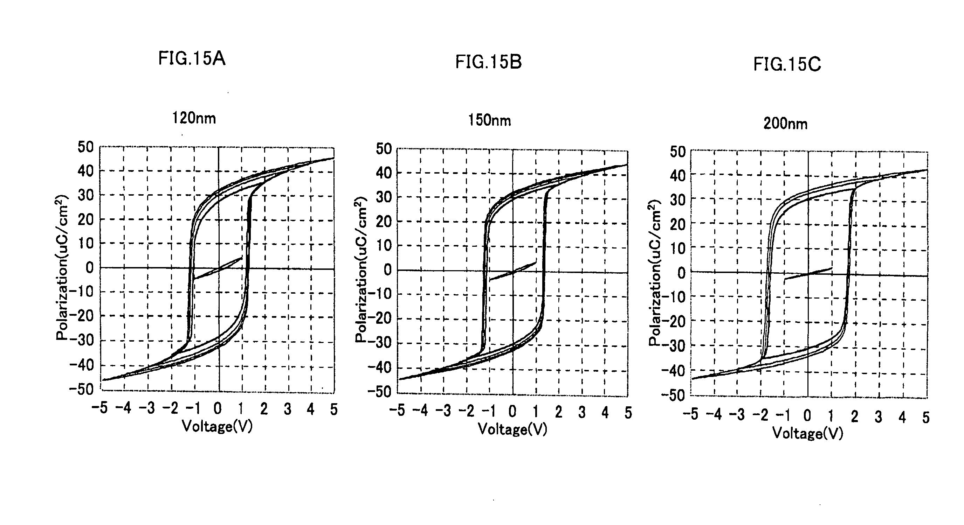

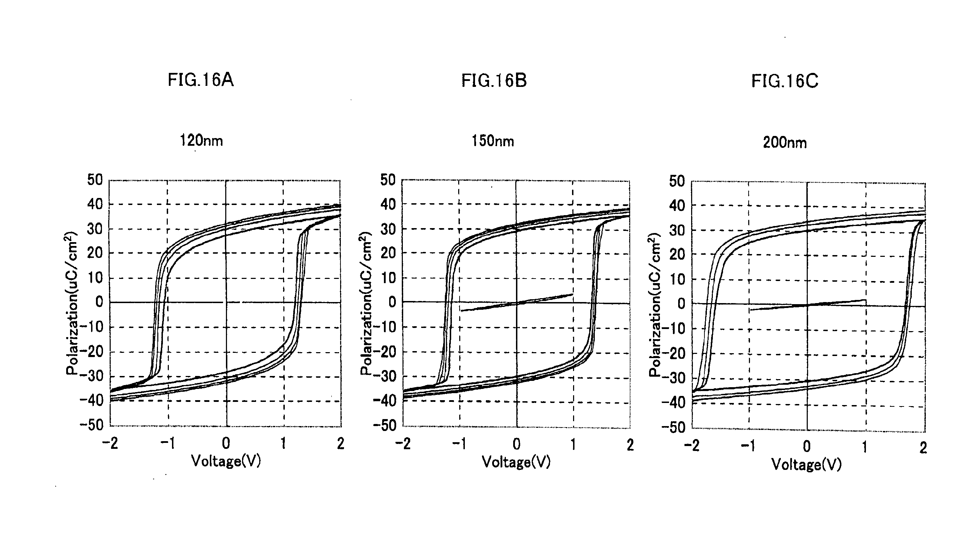

When changing the thickness of the PZTN thin film containing 1 mol% of PbSiO₃ in the range of 120 to 200 nm, each film exhibited crystallinity proportional to the thickness, as shown in FIGS. 13A to 13C and FIGS. 14A to 14C. FIGS. 13A to 13C are electron micrographs showing the surface morphology at a thickness of 120 to 200 nm, and FIGS. 14A to 14C are X-ray diffraction measurement results showing the crystallinity of the PZTN thin films with a thickness of 120 to 200 nm. As shown in FIGS. 15A to 15C and FIGS. 16A to 16C, hysteresis characteristics with excellent squareness were obtained at a thickness of 120 to 200 nm. FIGS. 16A to 16C are enlarged views of the hysteresis curves shown in FIGS. 15A to 15C. In particular, it was confirmed that the PZTN thin film of this example exhibited an excellent and saturated hysteresis curve at a low voltage of 2 V or less.

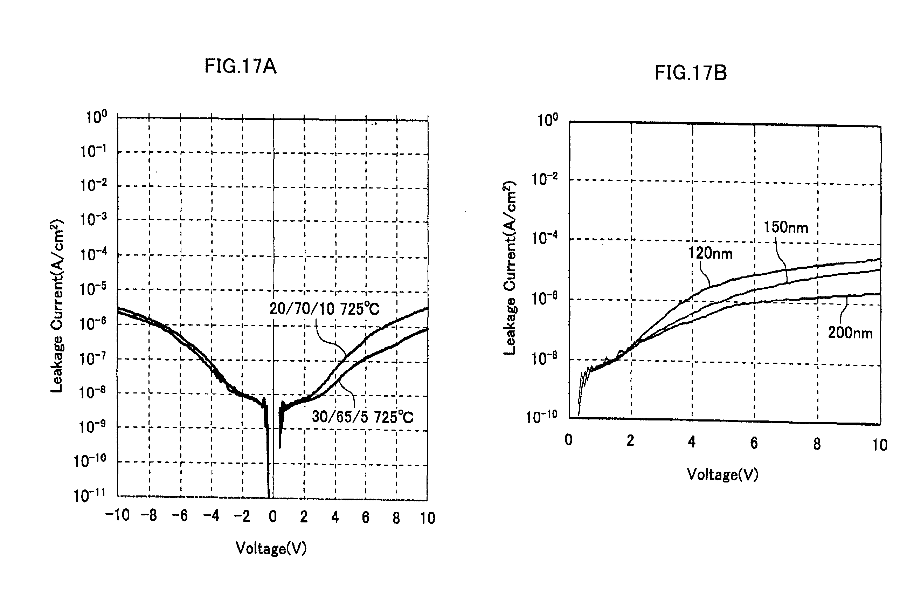

As shown in FIGS. 17A and 17B, the PZTN thin film of this example exhibited excellent leakage characteristics of 5 × 10⁻⁸ to 7× 10⁻⁹ A/cm² at an applied voltage of 2 V (saturated) irrespective of the composition and the thickness of the film.

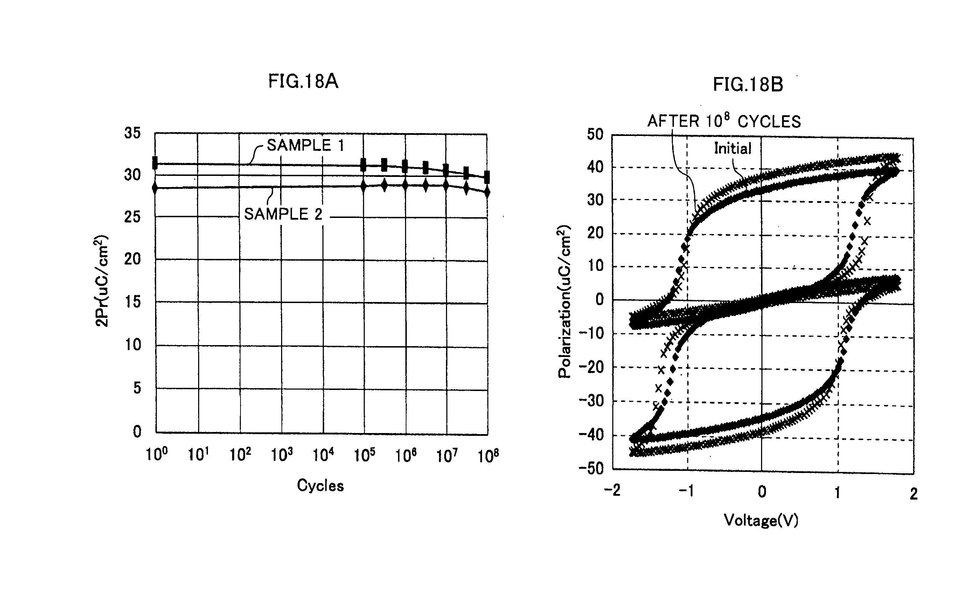

The fatigue characteristics and the static imprint characteristics of the PbZr_{0.2}Ti_{0.6}Nb_{0.2} thin film were measured. As shown in FIGS. 18A and 18B, excellent fatigue characteristics and static imprint characteristics were obtained. In particular, FIG. 18A shows that excellent fatigue characteristics were obtained, although Pt was used for the upper and lower electrodes.

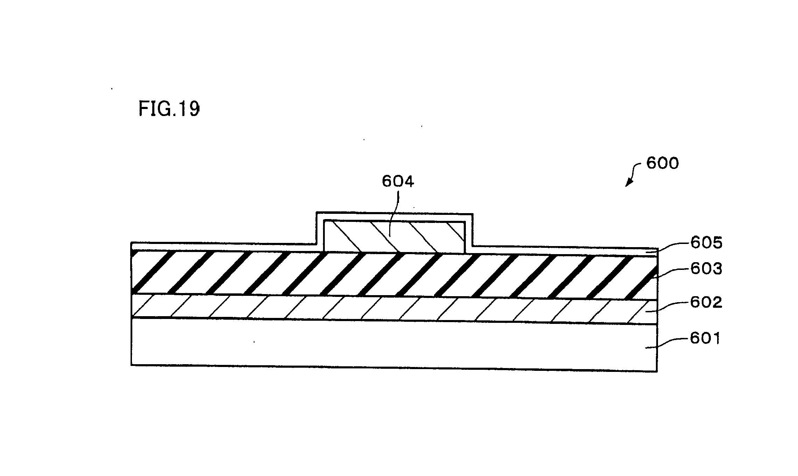

As shown in FIG. 19, an SiO₂ film 604 was formed by an ozone TEOS process on a complex metal oxide capacitor 600 in which a lower electrode 602, a PZTN complex metal oxide film 603 of this example, and an upper electrode 605 were formed on a substrate 601. When forming an SiO₂ film by an ozone TEOS process, known PZT is reduced by hydrogen generated from the TEOS and passing through the upper Pt, whereby the PZT crystal is destroyed to such an extent that the PZT does not exhibit hysteresis characteristics.

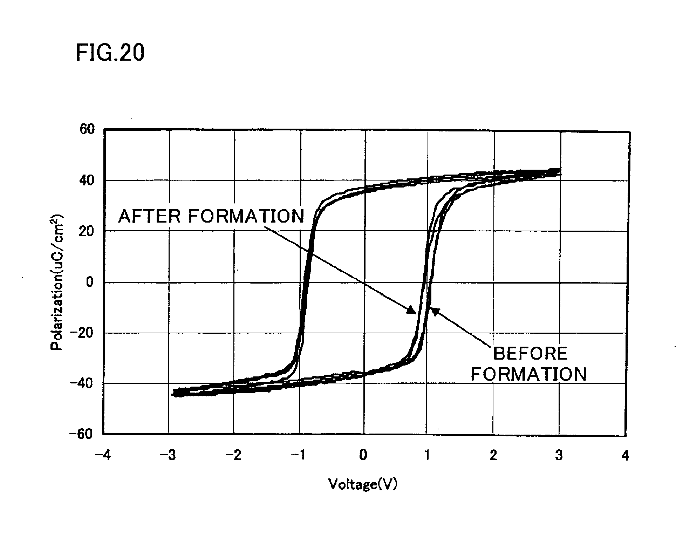

As shown in FIG 20, the PZTN complex metal oxide film 603 of this example deteriorated to only a small extent and maintained excellent hysteresis characteristics. Specifically, it was confirmed that the PZTN complex metal oxide film 603 of this example exhibited excellent reduction resistance. When the amount of Nb was 40 mol% or less, the tetragonal PZTN complex metal oxide film 603 according to the invention exhibited excellent hysteresis characteristics corresponding to the amount of Nb added.

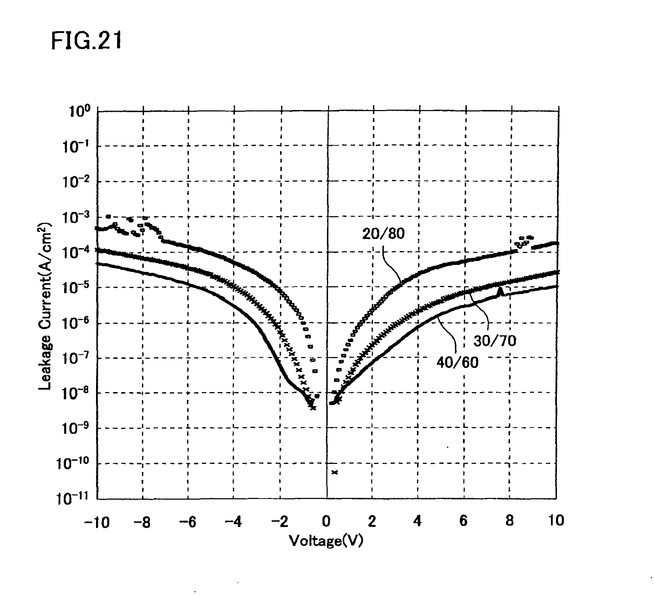

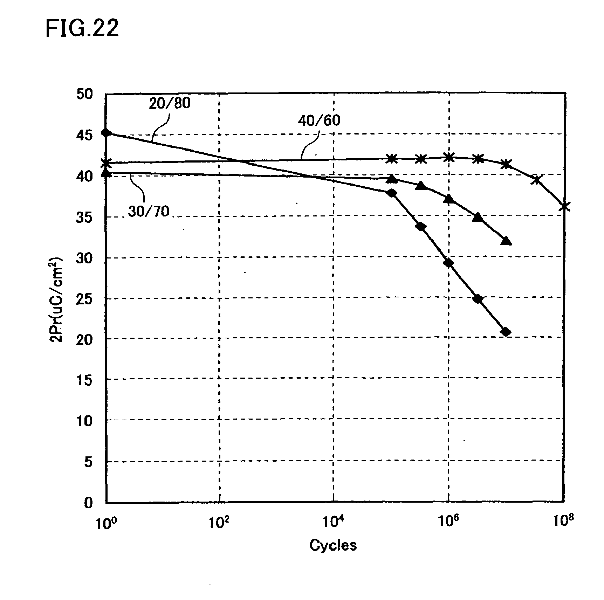

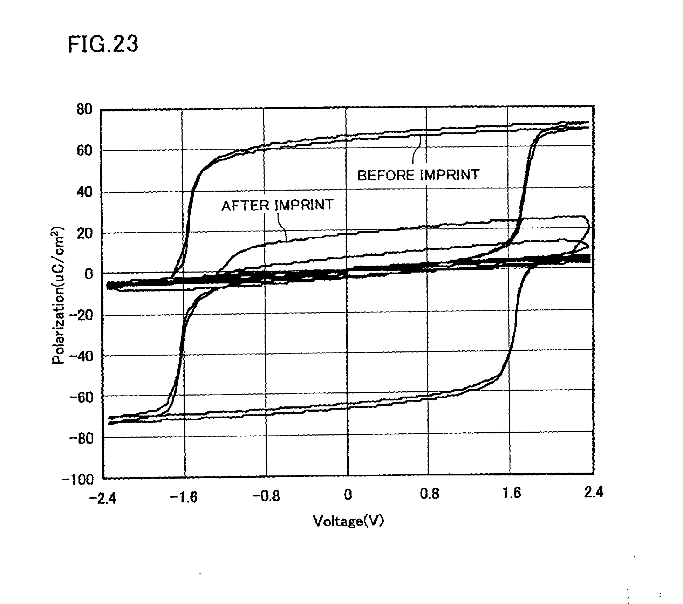

A known PZT complex metal oxide film was evaluated for comparison. The Pb:Zr:Ti ratio of known PZT was set at 1:0.2:0.8, 1:0.3:0.7, and 1:0.6:0.4. As shown in FIG 21, the leakage characteristics deteriorated to a larger extent as the Ti content became higher. When the Ti content was 80%, the leakage characteristics were 10⁻⁵ A/cm² at an applied voltage of 2 V This indicates that the known PZT complex metal oxide film is not suitable for memory applications. Likewise, the fatigue characteristics deteriorated as the Ti content became higher, as shown in FIG. 22. As shown in FIG. 23, it was found that data could not be read after an imprint.

As described above, the PZTN complex metal oxide film formed using the solution (raw material composition) of this example can solve the problems relating to an increase in leakage current and deterioration in imprint characteristics, which have been considered to be caused by the nature of PZT, and allows tetragonal PZT, which has not been used for memory applications for the above reasons, to be utilized for memory applications irrespective of the type and the structure of the memory. In addition, this material can also be utilized for various applications such as a piezoelectric device, for which tetragonal PZT has not been used for the above reasons.

### Example 4

In this example, the amount of Nb added to a PZTN complex metal oxide film was changed to 0, 5, 10, 20, 30, and 40 mol%, and the ferroelectric characteristics of the resulting films were compared. A PbSiO₃ silicate was added to all the samples in an amount of 5 mol%. A solution (raw material composition) was prepared in the same manner as in Example 2. Dimethyl succinate and n-butanol (organic solvent) were used.

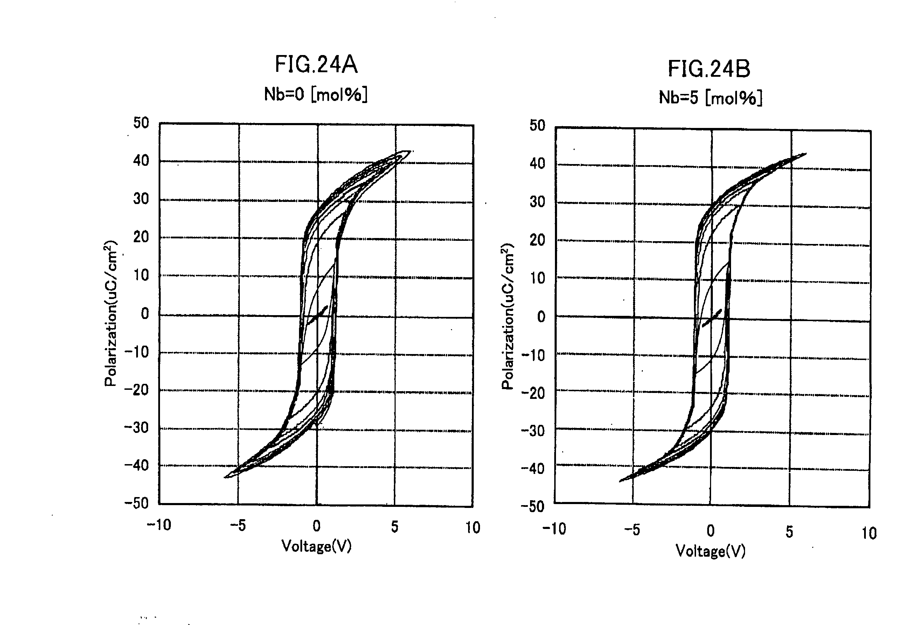

FIGS. 24A to 26B show the hysteresis characteristics of the PZTN complex metal oxide films of this example.

As shown in FIG 24A, leaky hysteresis characteristics were obtained when the amount of Nb added was zero. As shown in FIG 24B, excellent hysteresis characteristics with high insulating properties were obtained when the amount of Nb added was 5 mol % .

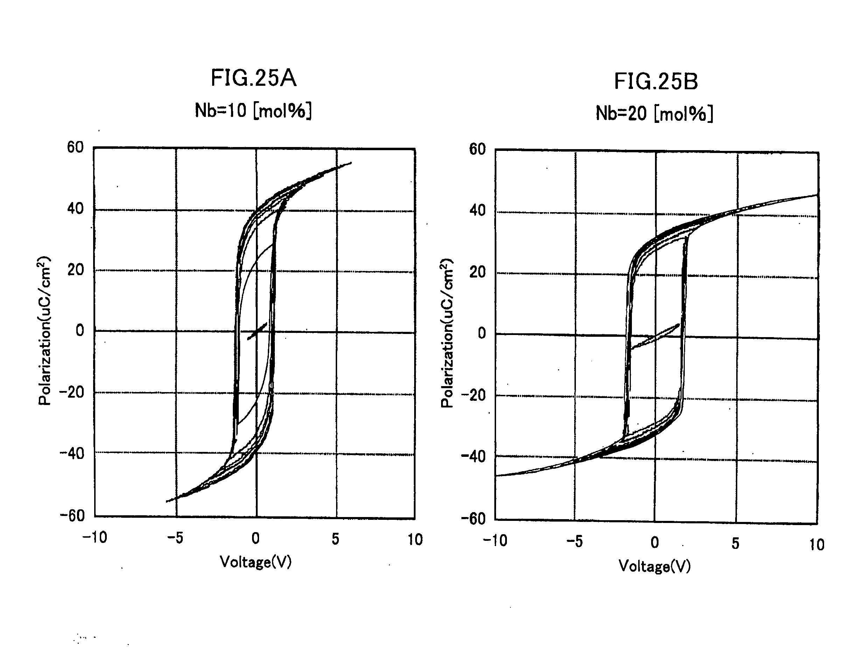

As shown in FIG 25A, the ferroelectric characteristics were changed to only a small extent when the amount of Nb added was 10 mol% or less. The ferroelectric characteristics were not changed when the amount of Nb added was zero, although leaky hysteresis characteristics were obtained. As shown in FIG. 25B, hysteresis characteristics with extremely excellent squareness were obtained when the amount of Nb added was 20 mol % .

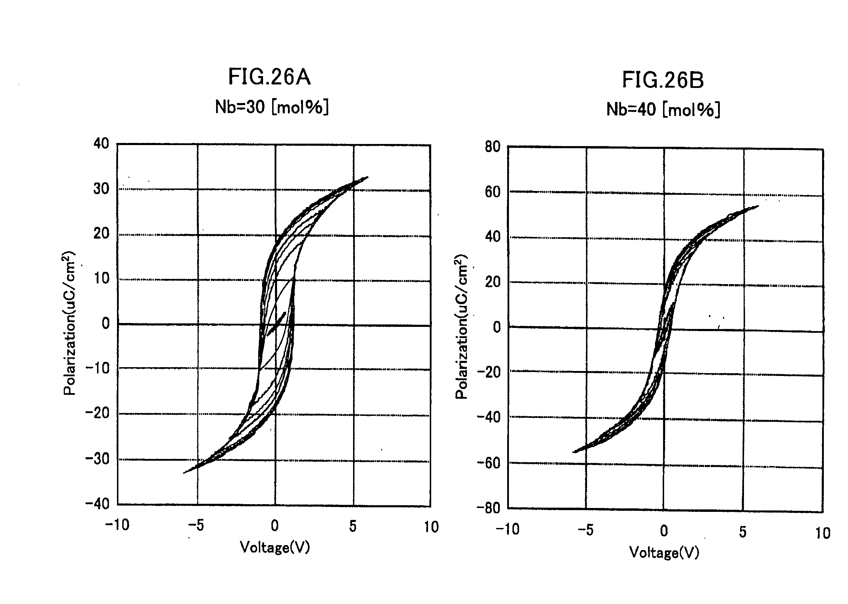

As shown in FIGS. 26A and 26B, it was confirmed that the hysteresis characteristics significantly changed and deteriorated when the amount of Nb added exceeded 20 mol%.

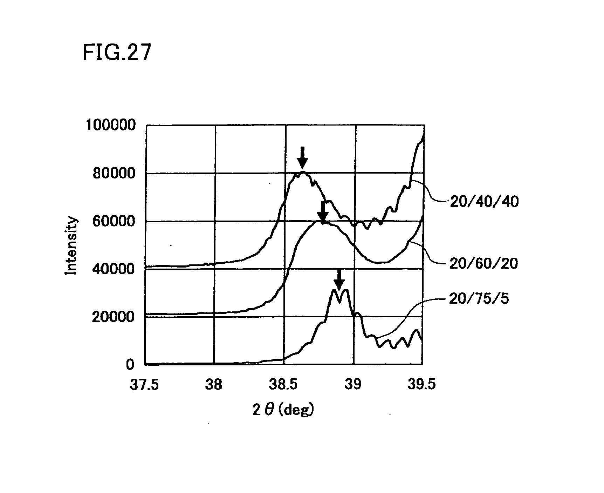

FIG. 27 shows the comparison results of the X-ray diffraction patterns. When the amount of Nb added was 5 mol% (Zr/Ti/Nb=20/75/5), the (111) peak position was the same as that of the known PZT film to which Nb was not added. On the other hand, the (111) peak shifted toward the lower angle side as the amount of Nb added was increased to 20 mol% (Zr/Ti/Nb=20/60/20) and 40 mol% (Zr/Ti/Nb=20/40/40). Specifically, although the composition of PZT was in the Ti-rich tetragonal region, the actual crystal was rhombohedral. Moreover, the characteristics of the complex metal oxide changed along with a change in the crystal system.

When Nb was added in an amount of 45 mol%, ferroelectric characteristics could not be confirmed due to the absence of hysteresis (not shown).

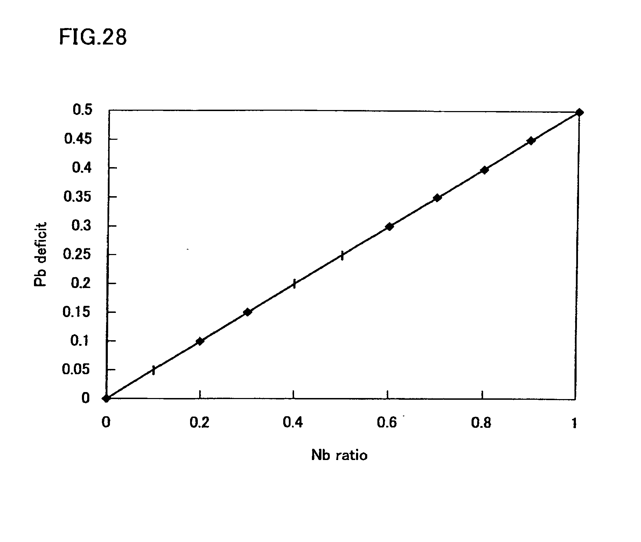

The PZTN thin film according to the invention exhibits very high insulating properties, as described above. FIG. 28 shows the conditions necessary for PZTN to be an insulator.

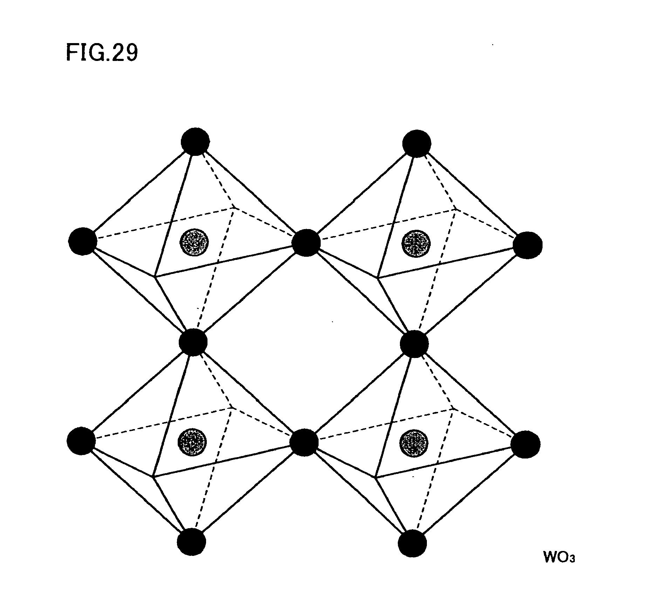

Specifically, since the PZTN thin film according to the invention exhibits very high insulating properties, Nb is added to the Ti site at a composition ratio corresponding to twice the amount of deficient Pb. As is clear from the WO₃ crystal structure shown in FIG 29, the perovskite crystal can be formed even if the A site ion is deficient at a percentage of 100%. It is known that the crystal system of WO₃ easily changes.

Accordingly, the amount of deficient Pb and the crystal system of PZTN are positively controlled by adding Nb.

This indicates that the PZTN film according to this embodiment is very effectively applied to a piezoelectric device such as an actuator and an ink jet head. In general, a Zr-rich rhombohedral region is used when applying PZT to a piezoelectric device. Zr-rich PZT is called soft PZT. This means that the soft PZT has a soft crystal. For example, the soft PZT is used for an ink-jet nozzle of an ink-jet printer. However, since the soft PZT is too soft, ink with a high viscosity cannot be discharged due to the pressure of the ink.

On the other hand, Ti-rich tetragonal PZT is called hard PZT. This means that the hard PZT is hard and brittle. However, the crystal system of the hard PZTN film according to the invention can be artificially changed to a rhombohedral system. Moreover, the crystal system can be arbitrarily changed by adjusting the amount of Nb added. Furthermore, since the Ti-rich PZT complex metal oxide film has a low relative dielectric constant, the resulting device can be driven at low voltage.

This enables the hard PZT to be used for an ink-jet nozzle of an ink-jet printer or the like, for which the hard PZT has not been used up to the present time. Since Nb provides PZT with softness, PZT can be provided which is moderately hard but is not brittle.

As described above, it was confirmed that the crystallization temperature can also be reduced by adding Si to the raw material composition of this example in addition to Nb.

### Comparative Example 1

A monocarboxylic acid ester was used for comparison instead of the dimethyl succinate used in Example 2.

Specifically, a solution was prepared in the same manner as in Example 2 except for adding 0.35 mol% of methyl acetate instead of dimethyl succinate. The resulting solution was spin-coated onto a Pt electrode substrate and sintered at 650°C for five minutes in an oxygen atmosphere to form a comparative ceramic thin film with a thickness of 150 nm.

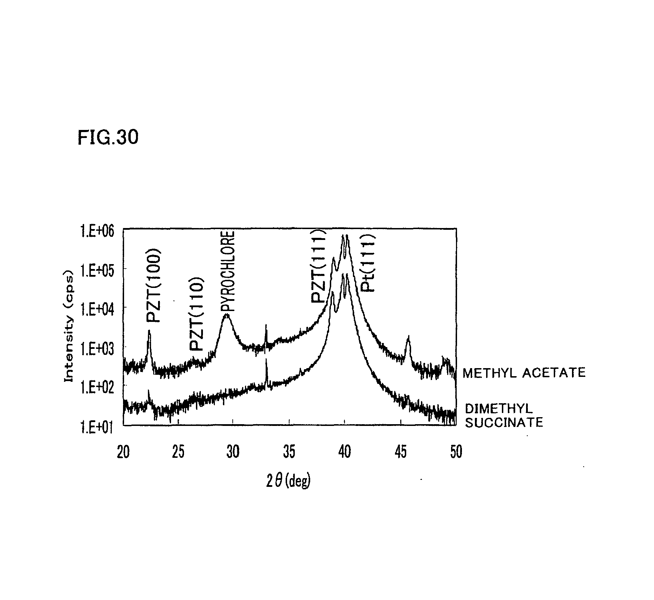

The crystallinity of the comparative sample was examined by X-ray diffraction analysis. As shown in FIG 30, a large amount of pyrochlore phase was observed when using methyl acetate. The pyrochlore phase is known as a low-temperature phase of PZT. Specifically, it was confirmed that the crystallization temperature when using methyl acetate was higher than when using dimethyl succinate.

Methyl acetate is a monocarboxylic acid ester and dissociates to produce acetic acid. Even if methyl acetate forms an ester bond with an alkoxide or an MOD raw material, the second or subsequent esterification forming the subsequent network does not occur, since methyl acetate is not a polycarboxylic acid. Therefore, a long network is not grown. It is considered that this caused an increase in the crystallization temperature in this comparative example.

### Example 5

In this example, raw material solutions were prepared using dimethyl succinate, dimethyl maleate, and dimethyl malonate as the polycarboxylic acid esters. A sample was formed in the same manner as in Example 2 using each raw material solution.

Specifically, a sol-gel raw material was used which was prepared by adding a raw material solution for forming a PbSiO₃ crystal to a raw material solution corresponding to PbZr_{0.17}Ti_{0.66}Nb_{0.17}O₃ (PZTN), prepared in the same manner as in Example 1, in an amount of 5 mol%. The sol-gel raw material and dimethyl succinate were dissolved in n-butanol at a ratio of 1:1, and the resulting solution was heated at 80°C for 60 minutes to obtain a solution (raw material composition).

A sample 1 was obtained as follows. The solution (raw material composition) was applied to a platinum substrate by spin coating, and dried at 150°C using a hot plate to remove the alcohol. A cleaning heat treatment was then performed at 300°C using a hot plate. The coating step, the drying step, and the cleaning heat treatment step were performed three times to obtain a coating film with a desired thickness. The coating film was then subjected to crystallization annealing (sintering) to obtain a complex metal oxide film with a thickness of 150 nm. The crystallization sintering was performed at 700°C in an oxygen atmosphere by rapid thermal annealing (RTA). The complex metal oxide film sample 1 was thus obtained.

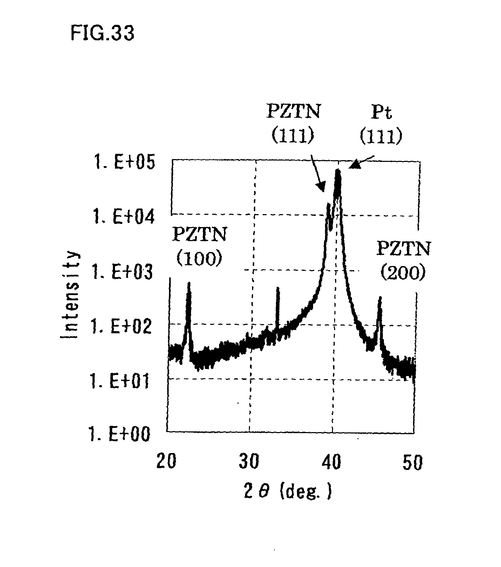

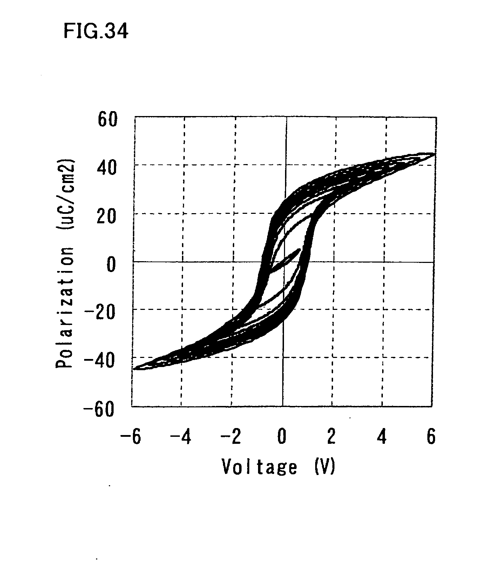

The crystallinity by means of X-ray diffraction analysis and the hysteresis characteristics of the sample 1 were examined in the same manner as in Example 1. FIG. 33 shows the X-ray analysis results, and FIG 34 shows the results of the hysteresis characteristics. As is clear from these results, it was confirmed that excellent PZTN was obtained when using dimethyl succinate.

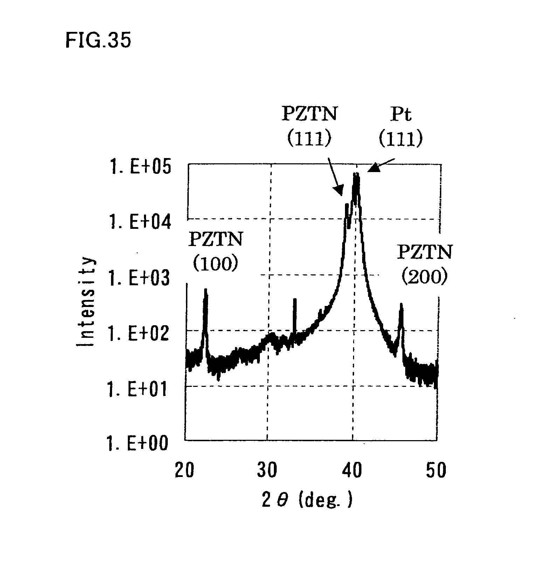

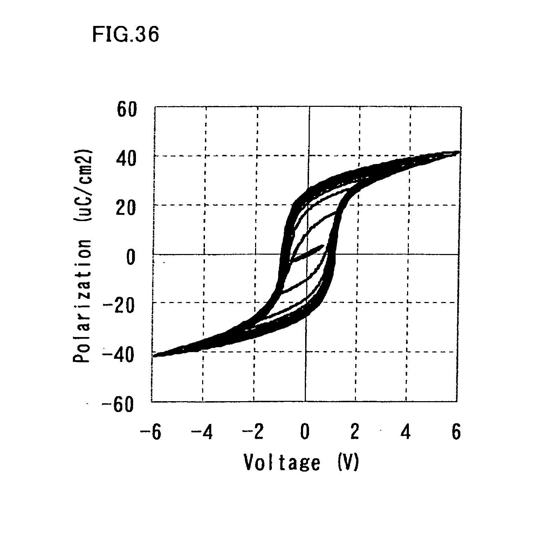

A complex metal oxide film sample 2 was obtained in the same manner as the sample 1 except for using dimethyl maleate instead of dimethyl succinate. The crystallinity by means of X-ray diffraction analysis and the hysteresis characteristics of the sample 2 were examined in the same manner as in Example 1. FIG 35 shows the X-ray analysis results, and FIG 36 shows the results of the hysteresis characteristics. As is clear from these results, it was confirmed that excellent PZTN was also obtained when using dimethyl maleate.

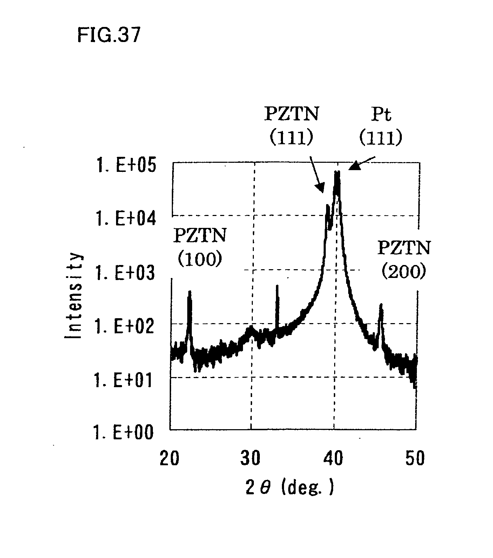

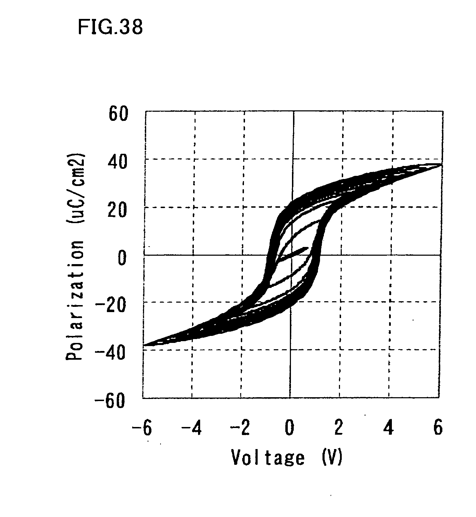

A complex metal oxide film sample 3 was obtained in the same manner as the sample 1 except for using dimethyl malonate instead of dimethyl succinate. The crystallinity by means of X-ray diffraction analysis and the hysteresis characteristics of the sample 3 were examined in the same manner as in Example 1. FIG 37 shows the X-ray analysis results, and FIG 38 shows the results of the hysteresis characteristics. As is clear from these results, it was confirmed that excellent PZTN was also obtained when using dimethyl malonate.

### Example 6

In this example, a raw material solution was prepared using an oxide containing Ta instead of Nb, and a sample was prepared in the same manner as in Example 2.

Specifically, a sol-gel raw material was used which was prepared by adding a raw material solution for forming a PbSiO₃ crystal to a raw material solution corresponding to PbZr_{0.17}Ti_{0.66}Ta_{0.17}O₃ (PZTT) in an amount of 5 mol%. A first raw material solution including Pb and Zr and a second raw material solution including Pb and Ti were the same as those used in Example 1. As a third raw material solution including Pb and Ta, a solution was used which was prepared by dissolving a condensate for forming a PbTaO₃ perovskite crystal in n-butanol in an anhydrous state.

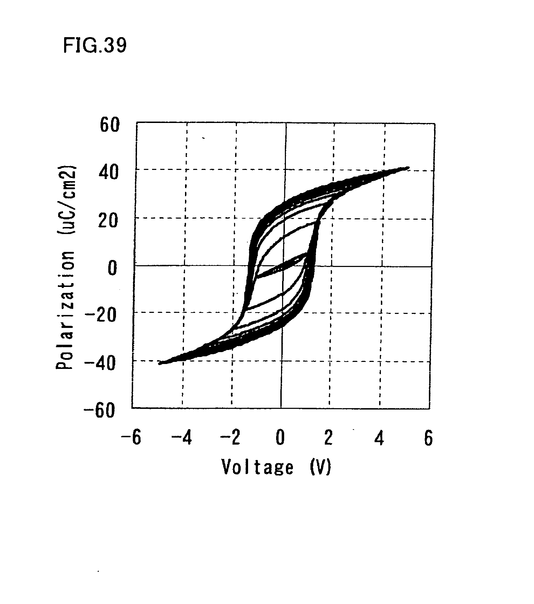

A complex metal oxide film sample was obtained in the same manner as in Example 1 using the resulting solution. The hysteresis characteristics of the sample were examined in the same as in Example 1. FIG 39 shows the results of the hysteresis characteristics. As is clear from these results, it was confirmed that excellent hysteresis characteristics were also obtained when using Ta instead of Nb.

### Example 7

In this example, a sample was formed in the same manner as in Example 1 except for changing the crystallization temperature.

Specifically, a sol-gel raw material was used which was prepared by adding a fourth raw material solution for forming a PbSiO₃ crystal to a raw material solution corresponding to PbZr_{0.2}Ti_{0.6}Nb_{0.2}O₃ (PZTN), prepared in the same manner as in Example 1, in an amount of 5 mol%. The sol-gel raw material and dimethyl succinate were dissolved in n-butanol at a ratio of 1:1, and the resulting solution was heated at 80°C for 60 minutes to obtain a solution (raw material composition).

The sample was obtained as follows. The solution (raw material composition) was applied by spin coating to a platinum substrate (substrate in which a silicon oxide layer, a titanium oxide layer, and a platinum layer were formed on a silicon substrate), and dried at 150°C using a hot plate to remove the alcohol. A cleaning heat treatment was then performed at 300°C using a hot plate. The coating step, the drying step, and the cleaning heat treatment step were performed three times to obtain a coating film with a desired thickness. The coating film was then subjected to crystallization annealing (sintering) to obtain a complex metal oxide film with a thickness of 150 nm. The crystallization sintering was performed at 600°C for 10 minutes in an oxygen atmosphere by rapid thermal annealing (RTA). A complex metal oxide film sample was thus obtained.

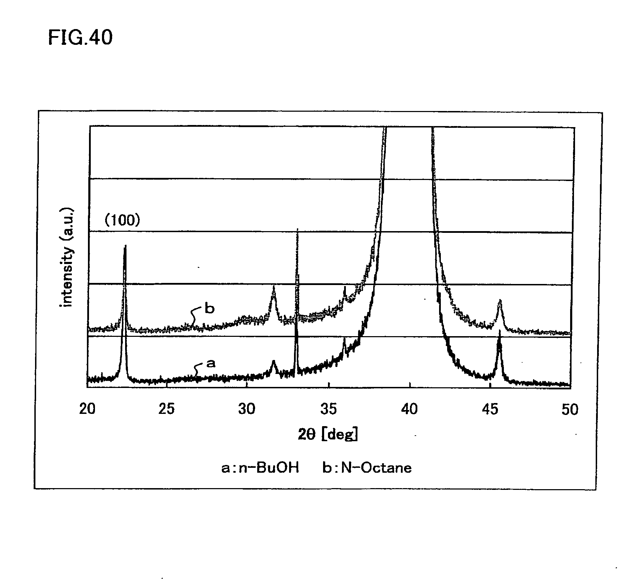

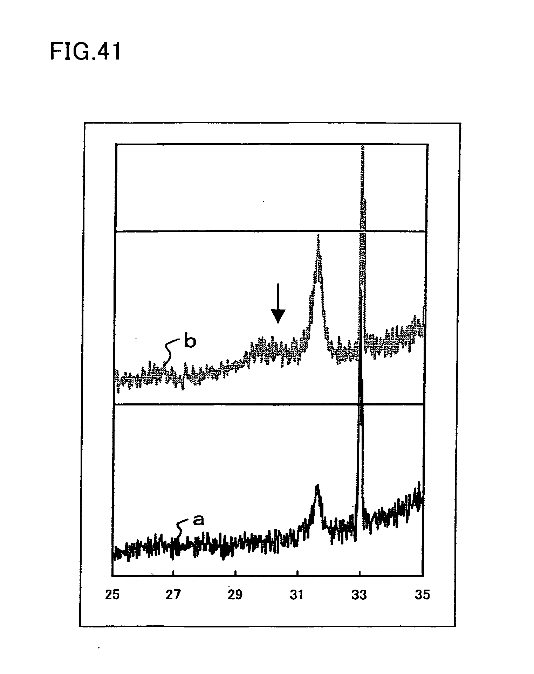

The crystallinity of the sample was examined by X-ray diffraction analysis in the same manner as in Example 1. FIG 40 shows the X-ray analysis results. In FIG. 40, the graph indicated by the symbol "a" shows the results of this example, and the graph indicated by the symbol "b" shows the results of Reference Example 1 described later. FIG. 41 is a partially enlarged view of FIG 40. As is clear from these results, it was confirmed that excellent PZTN was also obtained according to this example.

### Reference Example 1

A sample was prepared in the same manner as in Example 7 except for using n-octane (alkane) as the organic solvent instead of the n-butanol used in Example 7.

The crystallinity of the sample was examined by X-ray diffraction analysis in the same manner as in Example 1. FIGS. 40 and 41 show the X-ray analysis results. As is clear from these results, the pyrochlore peak was observed in this reference example at a portion indicated by the arrow in FIG. 41. Accordingly, it was confirmed that PZTN with more excellent crystallinity was obtained by using a polar solvent such as an alcohol as the organic solvent rather than a nonpolar solvent such as an alkane.

### Example 8

This example differs from Example 1 in that ethylene glycol was used as the organic solvent instead of n-butanol. In this example, a PZTN complex metal oxide film was obtained by mixing first to third raw material solutions, each including at least one of Pb, Zr, Ti, and Nb, dimethyl succinate as the polycarboxylic acid ester, and ethylene glycol (C₂H₆O₂: dihydric alcohol) as the organic solvent, and crystallizing the oxide contained in the mixed solution by heat treatment or the like. The mixed solution was prepared by dissolving the raw material solutions and dimethyl succinate in ethylene glycol at a ratio of 1:1.

As the first raw material solution, a solution was used in which a polycondensate for forming a PbZrO₃ perovskite crystal containing Pb and Zr among the constituent metal elements of the PZTN complex metal oxide phase was dissolved in ethylene glycol in an anhydrous state.

As the second raw material solution, a solution was used in which a polycondensate for forming a PbTiO₃ perovskite crystal containing Pb and Ti among the constituent metal elements of the PZTN complex metal oxide phase was dissolved in ethylene glycol in an anhydrous state.

As the third raw material solution, a solution was used in which a polycondensate for forming a PbNbO₃ perovskite crystal containing Pb and Nb among the constituent metal elements of the PZTN complex metal oxide phase was dissolved in ethylene glycol in an anhydrous state.

When forming a PbZr_{0.2}Ti_{0.6}Nb_{0.2}O₃ (PZTN) complex metal oxide film using the first, second, and third raw material solutions, the raw material solutions are mixed at a ratio of (first raw material solution):(second raw material solution):(third raw material solution) = 2:6:2. In order to reduce the crystallization temperature of the complex metal oxide film, a solution prepared by dissolving a polycondensate for forming a PbSiO₃ crystal in ethylene glycol in an anhydrous state was added to the mixed solution as a fourth raw material solution in an amount of 1.5 mol% . Specifically, PZTN can be crystallized at 650°C by using the mixed solution of the first, second, third, and fourth raw material solutions as the raw material composition.

A sample was obtained as follows.

The first to fourth raw material solutions and dimethyl succinate were dissolved in ethylene glycol at room temperature to prepare a solution. The solution was then sealed in a container and heated at 90°C for 30 minutes, and then cooled to room temperature to obtain a raw material composition.

The raw material composition was applied to a platinum substrate by spin coating, and dried at 150°C using a hot plate to remove the alcohol. A cleaning heat treatment was then performed at 300°C using a hot plate. The coating step, the drying step, and the cleaning heat treatment step were performed three times. The resulting product was subjected to crystallization annealing (sintering) at 650°C for five minutes in oxygen to obtain a complex metal oxide film sample with a thickness of 120 nm. The crystallization sintering was performed in an oxygen atmosphere by rapid thermal annealing (RTA) at a temperature increase rate of 120°C/second. A platinum upper electrode was then formed by sputtering to obtain a complex metal oxide capacitor sample.

The following characteristics were examined using the resulting sample.

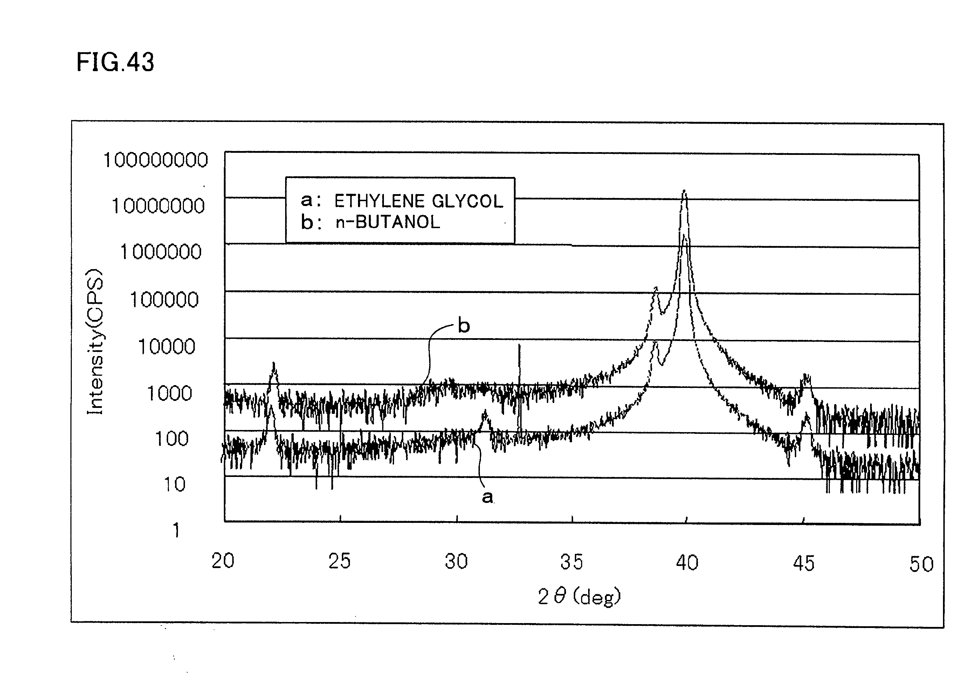

The crystallinity of the capacitor sample was examined by X-ray diffraction analysis. The results are shown in FIG 43. In FIG 43, the XRD pattern indicated by the symbol "a" shows the results of this example using ethylene glycol, and the XRD pattern indicated by the symbol "b" shows the results of Example 2 using n-butanol. As is clear from FIG 43, it was found that PZTN of this example was formed of a perovskite single phase in the same manner as in Example 2.

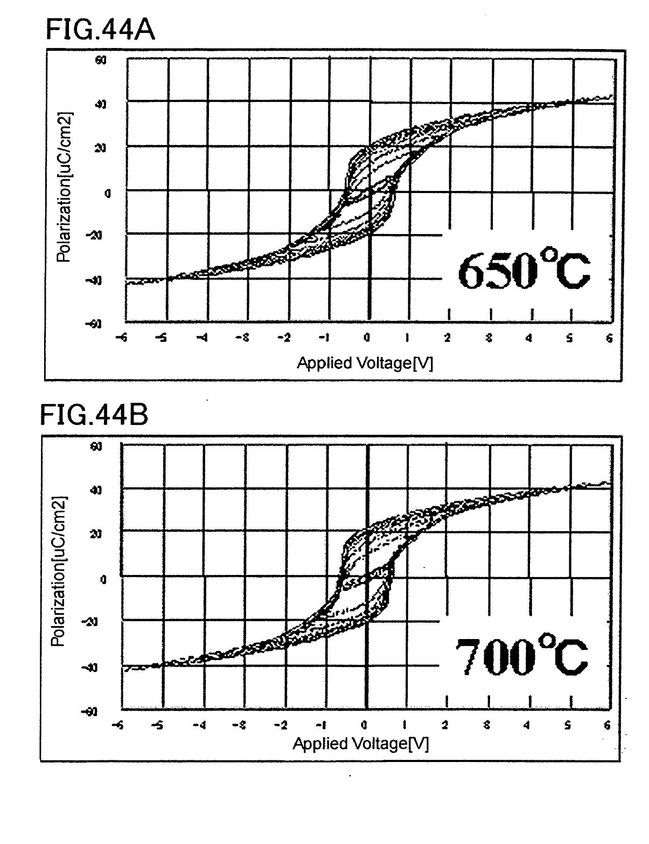

The hysteresis characteristics of the capacitor sample of this example were evaluated. As shown in FIG 44A, excellent hysteresis characteristics were obtained.

FIG 44B shows the hysteresis characteristics of a capacitor sample obtained in the same manner as in this example except for changing the sintering temperature to 700°C. In this case, excellent hysteresis characteristics were also obtained.

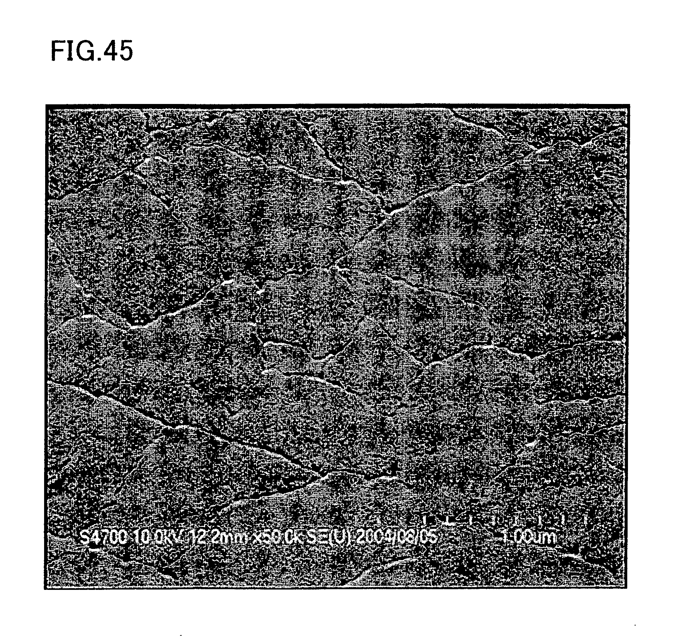

The surface morphology of the capacitor sample of this example was examined by SEM. As shown in FIG 45, excellent results were obtained.

### Example 9

In this example, a PZTN complex metal oxide film was obtained by mixing first to third raw material solutions, each including at least one of Pb, Zr, Ti, and Nb, dimethyl succinate, dimethyl maleate, dimethyl malonate, or tributyl citrate as the polycarboxylic acid ester, and n-butanol as the organic solvent, and crystallizing the oxide included in the mixed solution by heat treatment or the like. The mixed solution was prepared by dissolving the sol-gel raw material and dimethyl succinate, dimethyl maleate, dimethyl malonate, or tributyl citrate in n-butanol at a ratio of 1:1.

As the first raw material solution, a solution was used in which a polycondensate for forming a PbZrO₃ perovskite crystal containing Pb and Zr among the constituent metal elements of a PZTN complex metal oxide phase was dissolved in n-butanol in an anhydrous state.

As the second raw material solution, a solution was used in which a polycondensate for forming a PbTiO₃ perovskite crystal containing Pb and Ti among the constituent metal elements of a PZTN complex metal oxide phase was dissolved in n-butanol in an anhydrous state.

As the third raw material solution, a solution was used in which a polycondensate for forming a PbNbO₃ perovskite crystal containing Pb and Nb among the constituent metal elements of a PZTN complex metal oxide phase was dissolved in n-butanol in an anhydrous state.

When forming a PbZr_{0.2}Ti_{0.6}Nb_{0.2}O₃ (PZTN) complex metal oxide film using the first, second, and third raw material solutions, the raw material solutions are mixed at a ratio of (first raw material solution):(second raw material solution):(third raw material solution) = 2:6:2. In order to reduce the crystallization temperature of the complex metal oxide film, a solution prepared by dissolving a polycondensate for forming a PbSiO₃ crystal in n-butanol in an anhydrous state was added to the mixed solution as a fourth raw material solution in an amount of 1.5 mol%. A PZTN raw material composition was thus prepared. The solutions respectively prepared using dimethyl succinate, dimethyl maleate, dimethyl malonate, and tributyl citrate are referred to as PZTN raw material compositions a, b, c, and d.

A capacitor sample was obtained as follows.

Each of the PZTN raw material compositions a, b, c, and d was applied to a platinum substrate by spin coating at room temperature, and dried at 150°C using a hot plate to remove the alcohol. A cleaning heat treatment was then performed at 300°C using a hot plate. The coating step, the drying step, and the cleaning heat treatment step were performed three times. The resulting product was subjected to crystallization annealing (sintering) at 650°C for five minutes in oxygen to obtain complex metal oxide film samples a, b, c, and d with a thickness of 120 nm. The crystallization sintering was performed in an oxygen atmosphere by rapid thermal annealing (RTA) at a temperature increase rate of 120°C/second. A platinum upper electrode was then formed by sputtering to obtain complex metal oxide capacitor samples a, b, c, and d.

The following characteristics were examined using the resulting samples.

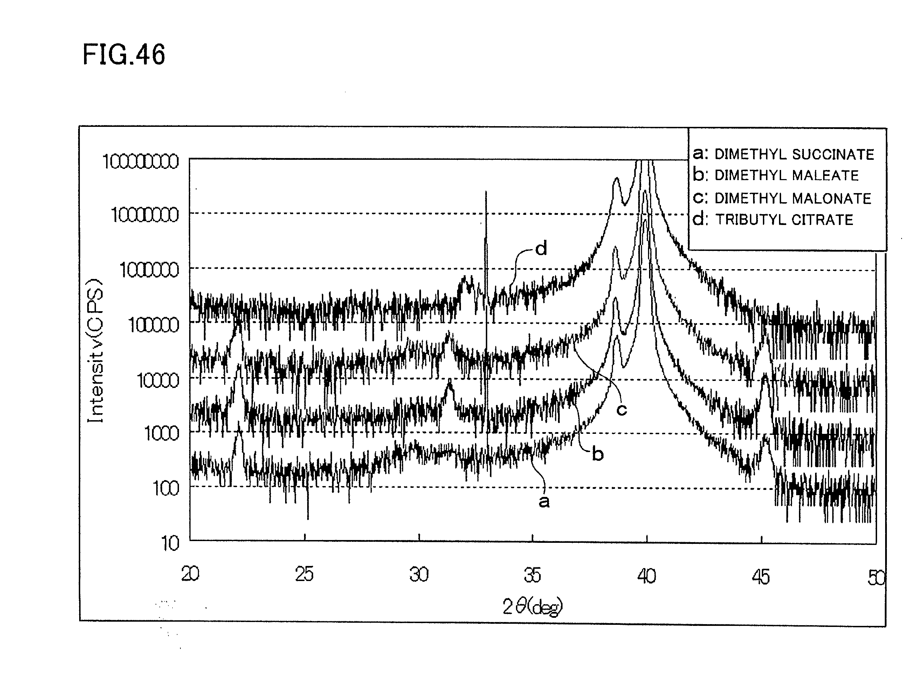

The crystallinity of the capacitor samples a, b, c, and d was examined by X-ray diffraction analysis. The results are shown in FIG. 46. As is clear from FIG 46, it was found that the capacitor samples a, b, c, and d were formed of a perovskite single phase.

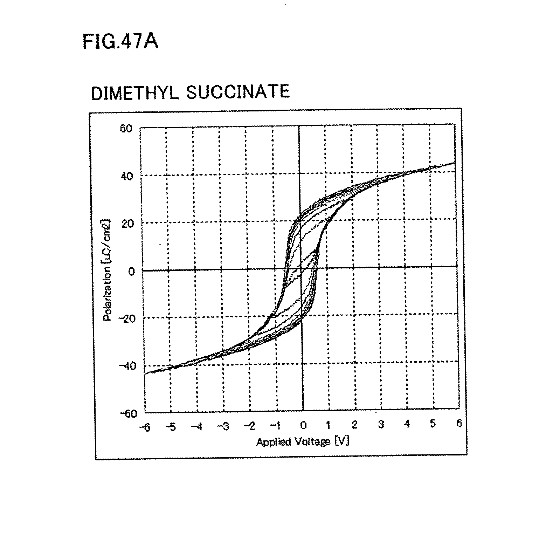

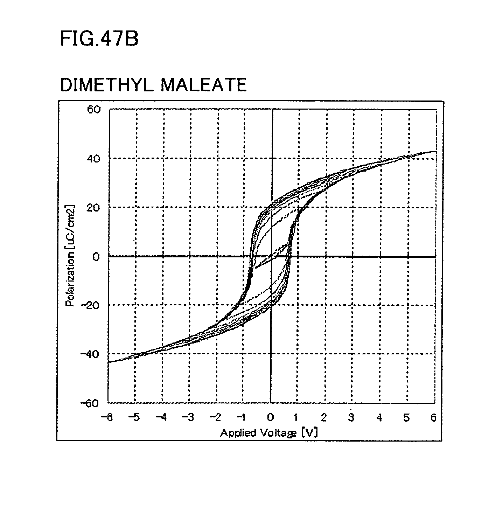

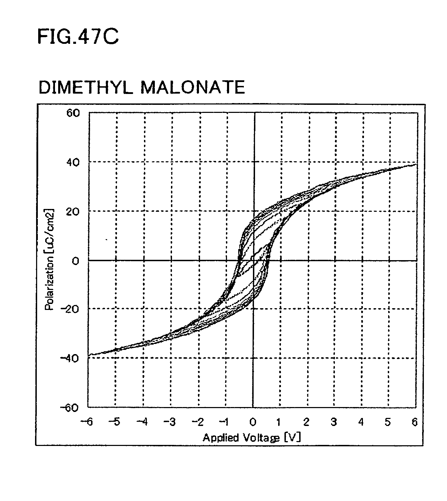

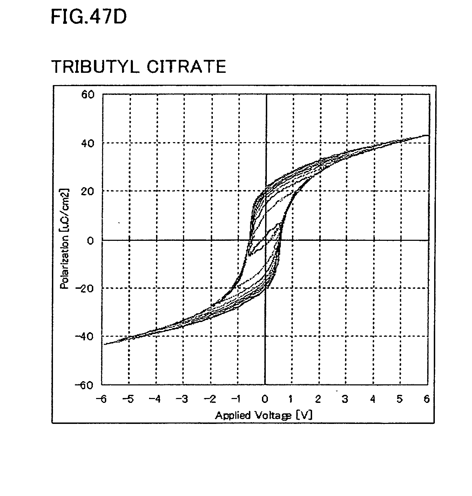

The hysteresis characteristics of the capacitor samples a, b, c, and d were evaluated. As shown in FIGS. 47A to 47D, excellent hysteresis characteristics were obtained.

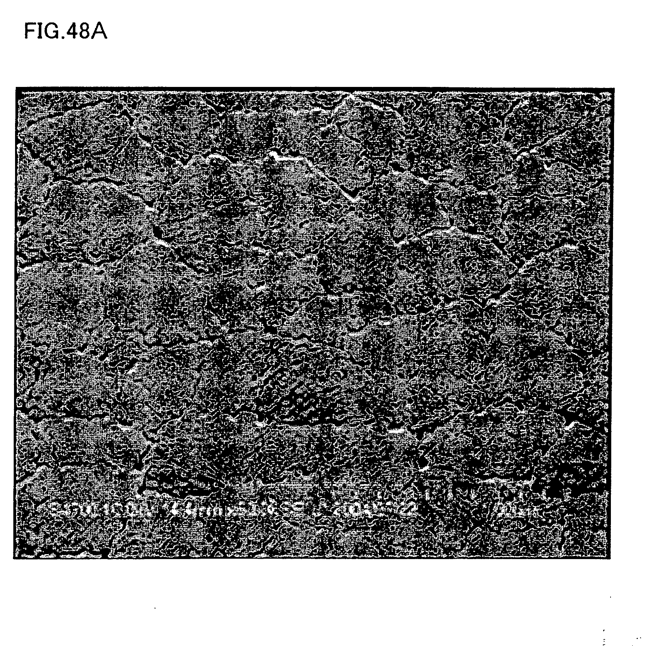

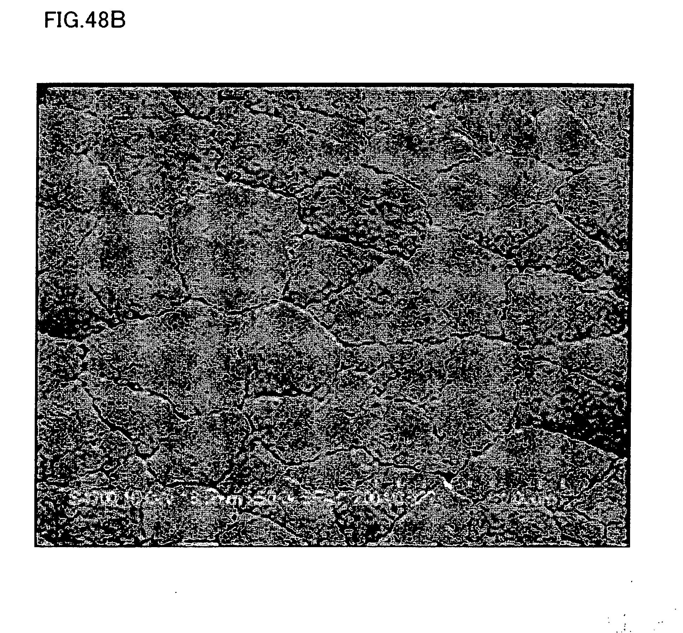

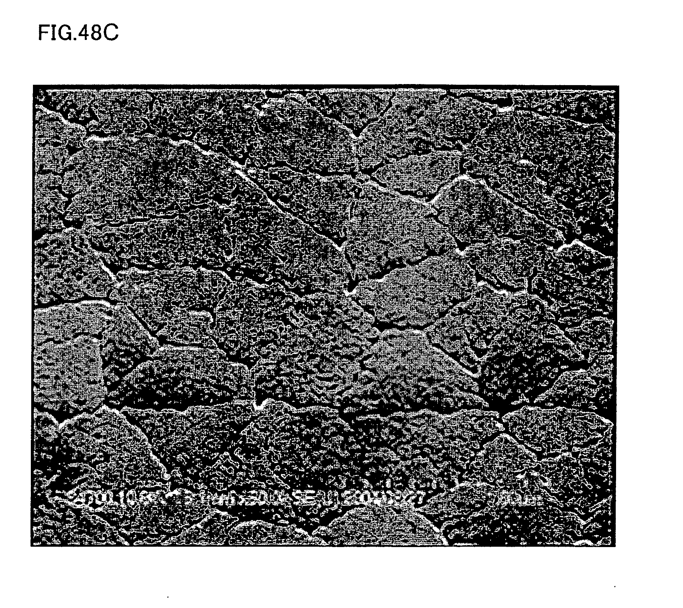

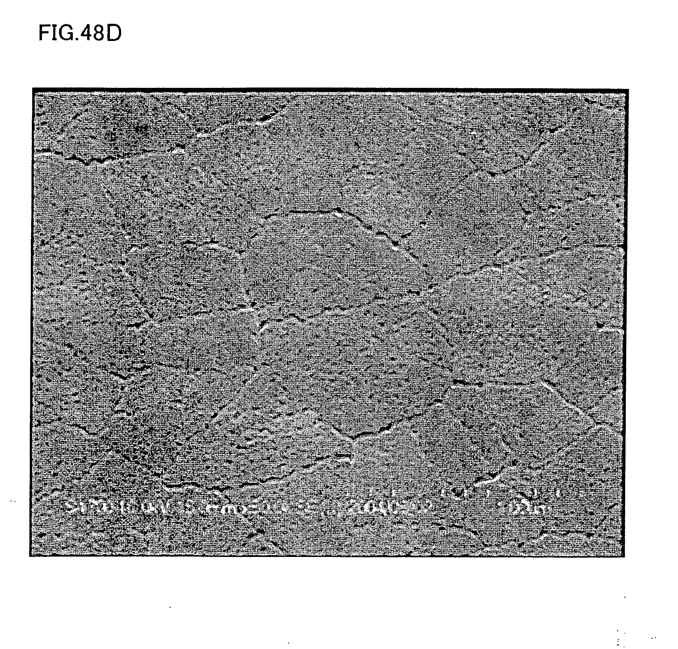

The surface morphology of the complex metal oxide (PZTN) film samples a, b, c, and d was examined by SEM. As shown in FIGS. 48A to 48D, it was confirmed that all the samples had a dense and smooth surface morphology.

### 4. Reaction mechanism

The reaction mechanism when forming a complex metal oxide using the raw material composition according to the invention is examined below.

### 4.1. Solution using titanium alkoxide

In order to simplify the alkoxide reaction mechanism, ¹H-NMR results of a solution including a titanium alkoxide are discussed below.

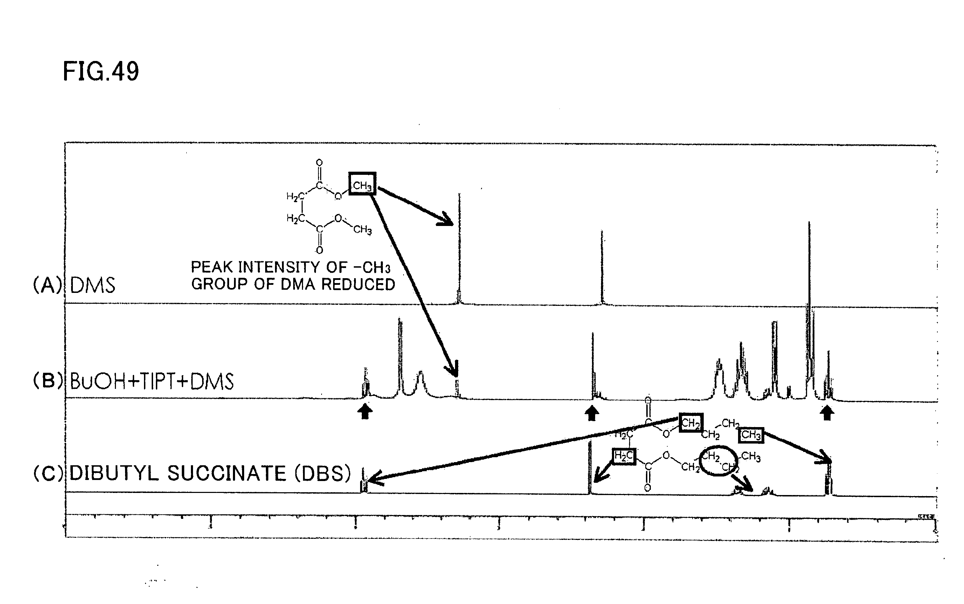

In more detail, a solution was prepared by dissolving Ti[OCH(CH₃)₂]₄ (TIPT) (titanium alkoxide) and dimethyl succinate (DMS) in n-butanol (BuOH), and the BuOH was evaporated by heating the solution to obtain a solution (1) (concentrated solution). The solution (1) was subjected to ¹H-NMR analysis. The results are shown in FIG 49. In FIG. 49, (A) indicates the chart of DMS, (B) indicates the chart of the solution (1), and (C) indicates the chart of dimethyl succinate (DBS). The following items were confirmed by comparing these charts.

Specifically, when comparing the chart (A) with the chart (B), the peak intensity of a methyl group (-CH₃) of DMS was significantly reduced in the chart of the solution (1) prepared by concentrating BuOH, TIPT, and DMS. The peaks which additionally appeared in the chart (B) (peaks indicated by the arrows in FIG 49) exist at the same positions as the peaks in the chart (C) of DBS. Accordingly, it is considered that dibutyl succinate was produced in the concentrated solution (1).

### 4.2. PZTNS raw material composition

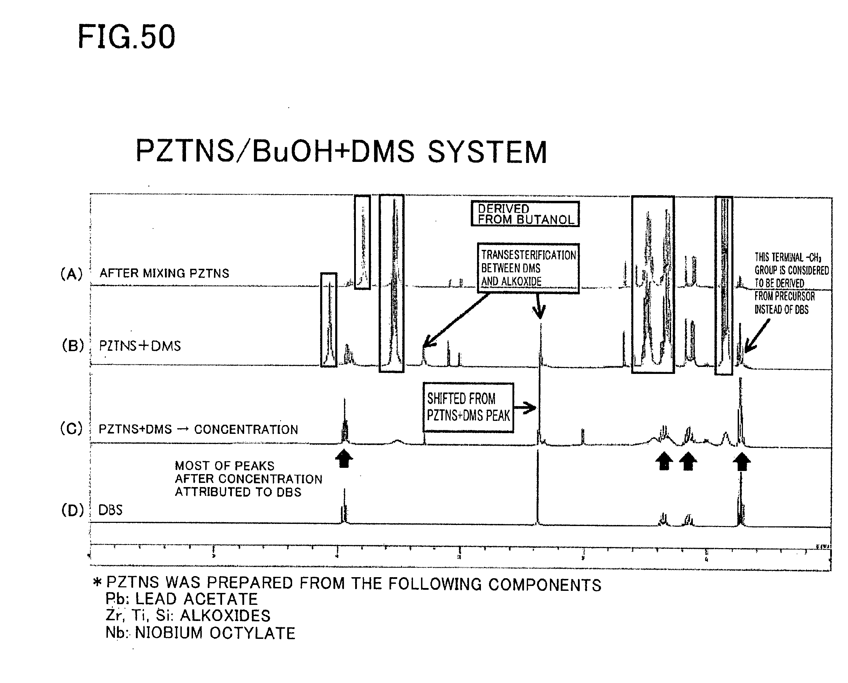

A raw material composition for PZTNS (complex metal oxide in which Si is added to Pb(Zn,Ti,Nb)O₃) was subjected to ¹H-NMR analysis. The results are shown in FIG 50. In FIG 50, (A) indicates the chart of a solution (1) prepared by mixing organometallic compounds of Pb, Zr, Ti, Si, and Nb and DMS in BuOH at room temperature. Lead acetate was used as the organometallic compound of Pb. Alkoxides were respectively used as the organometallic compounds of Zr, Ti, and Si. Niobium octylate was used as the organometallic compound of Nb. In the solution (1), the total number of moles of the metals was equal to the number of moles of DMS.

(B) indicates the chart of a concentrated solution (2) prepared by heating the solution (1) to partially remove the BuOH. (C) indicates the chart of a concentrated solution (3) prepared by heating the solution (2) to almost completely remove the BuOH. (D) indicates the chart of DBS.

The following items were confirmed from FIG. 50. Specifically, when comparing the charts (A) and (B), transesterification occurred between the DMS and the alkoxide due to removal of the BuOH. When comparing the charts (B), (C), and (D), the peaks attributed to butyl groups are observed at the positions indicated by the arrows in the chart (C) of the solution (3) from which the BuOH was removed. These peaks coincide with the peaks in the chart (D) of DBS. Accordingly, it is considered that DBS was produced in the solution from which butanol was removed.

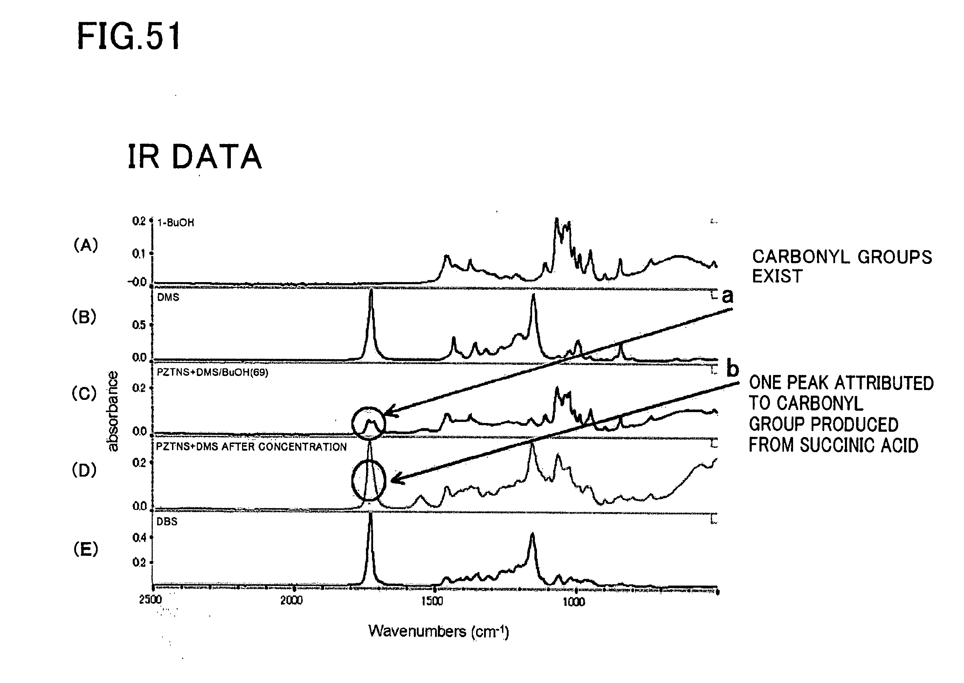

FIG. 51 shows IR analysis results. In FIG 51, (A) indicates the chart of BuOH, (B) indicates the chart of DMS, (C) indicates the chart of the solution (1), (D) indicates the solution (3) prepared by concentrating the solution (1) to almost completely remove the BuOH, and (E) indicates the chart of DBS. The following items were confirmed by comparing these charts.

As is clear from the chart (C), the peaks (peaks indicated by the arrow a) attributed to carbonyl groups produced by transesterification between the DMS and the alkoxide or produced from various alkoxides are observed for the solution (1). As is clear from the chart (D), the peak (peak indicated by the arrow b) attributed to a carbonyl group produced from succinic acid is observed for the solution (3) from which the BuOH was removed. Accordingly, it is considered that most of the peaks attributed to succinic acid are attributed to dibutyl succinate by removing n-butanol.

### 4.3. Consideration

As described above, it is considered that the following reactions occur in a coating film formed on a substrate using the raw material composition according to the invention.

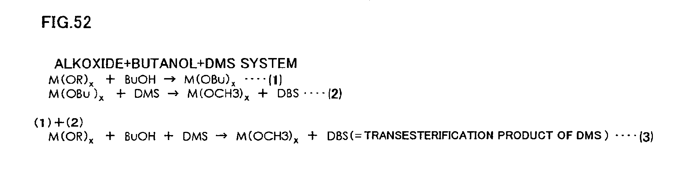

It is considered that the reactions of the formulas (1), (2), and (3) in FIG 52 occur in a solution containing a metal alkoxide, dimethyl succinate, and n-butanol along with removal of the n-butanol. Specifically, all the alkoxides change into butoxides (-OBu) in the presence of n-butanol, and the butoxide undergoes transesterification with dimethyl succinate (DMS) to produce dibutyl succinate (DBS).

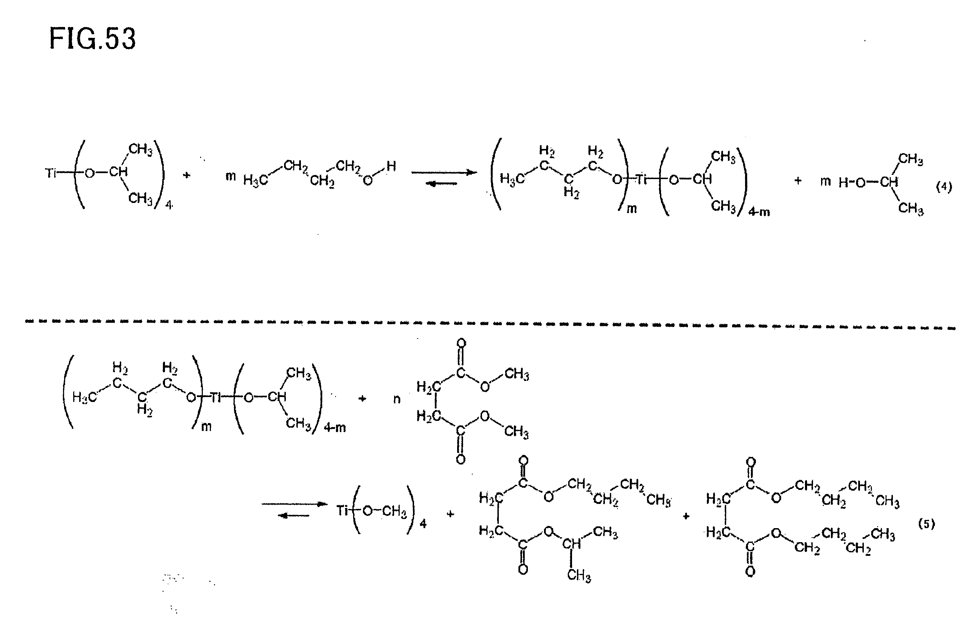

In order to allow the above reactions to be more readily understood, the above reactions are described below with reference to FIG. 53 which shows an example using TIPT as the alkoxide.

As indicated by the formula (4), a butoxide (Ti-OBu) and 2-propanol are produced by the alcohol exchange reaction between the alkoxide and n-butanol. 2-Propanol is easily evaporated due to its low boiling point. Therefore, the equilibrium shifts in the direction (right) in which propanol is produced by heating the system.

As indicated by the formula (5), butyl succinate and methoxide (Ti-OMe) are produced by the transesterification between the butoxide and DMS. Since only the alkoxide undergoes transesterification, excess DMS exists when other organometallic compounds exist, whereby the equilibrium shifts in the direction (right) in which the amount of DMS is reduced.

The metal alkoxide included in the raw material composition is finally converted into a metal methoxide in this manner. The metal methoxide thus formed has a very small molecular size and is considered to form a more dense gel. The boiling point of butanol used as the solvent is 117°C, and the boiling point of dimethyl succinate (DMS) is 195.3°C. When butanol is evaporated and dimethyl succinate changes into dibutyl succinate, the metal methoxide sol exists on the substrate as a dibutyl succinate solution. This solution exhibits solvent effects with a high boiling point and excellent wettability.

It is considered that the above reactions proceed along with evaporation of the solvent (e.g. n-butanol) after applying the raw material composition (PZTNS solution) to the substrate.

It has been confirmed by NMR analysis that the organometallic compounds other than the alkoxide such as niobium octylate and lead octylate do not undergo exchange reaction in the solvent (n-butanol) or reaction with dimethyl succinate. Specifically, these components exist in the raw material composition in the form of octylates.

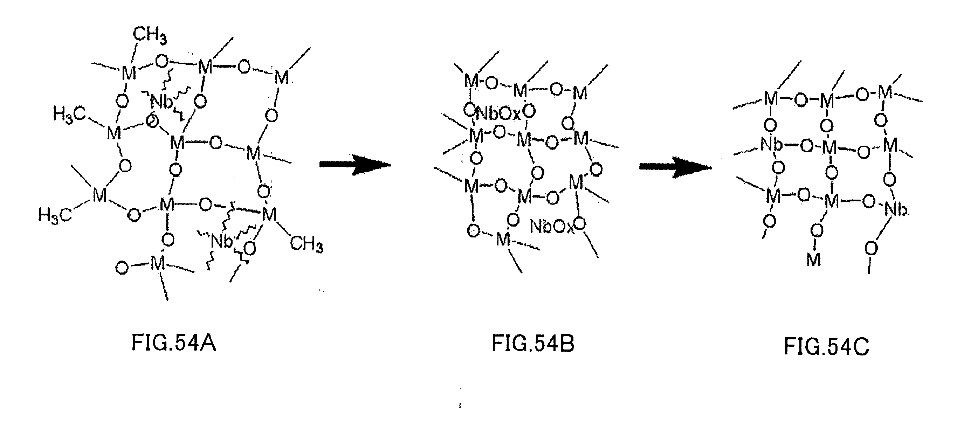

FIG. 54 schematically shows the behavior of niobium octylate. As indicated by (A) in FIG. 54, niobium octylate is mixed with the metal methoxide sol (precursor) produced according to the above-described mechanism. As indicated by (B), when the temperature has reached the thermal decomposition temperature of the precursor, niobium octylate independently forms niobium oxide. When the temperature is further increased, niobium replaces the PZT crystal lattice, as indicated by (C).

The above reaction mechanism has been described taking a specific substance as an example. It is considered that the above reaction mechanism may also be applied to other substances.

The application example of the raw material composition according to this embodiment is not limited. The raw material composition according to this embodiment may be applied to various devices such as a ferroelectric memory, a piezoelectric actuator, a piezoelectric pump, a surface acoustic wave (SAW) device, a thin-film piezoelectric resonator, a frequency filter, and an oscillator (e.g. voltage-controlled SAW oscillator).

The invention is not limited to the above-described embodiments, and various modifications can be made. For example, the invention includes various other configurations substantially the same as the configurations described in the embodiments (in function, method and result, or in objective and result, for example). The invention also includes a configuration in which an unsubstantial portion in the described embodiments is replaced. The invention also includes a configuration having the same effects as the configurations described in the embodiments, or a configuration able to achieve the same objective. Further, the invention includes a configuration in which a publicly known technique is added to the configurations in the embodiments.

Although only some embodiments of the invention have been described in detail above, those skilled in the art will readily appreciate that many modifications are possible in the embodiments without materially departing from the novel teachings and advantages of this invention. Accordingly, all such modifications are intended to be included within the scope of the invention.

## Claims

1. A complex metal oxide raw material composition used for forming a complex metal oxide,
the complex metal oxide being shown by a general formula AB₁₋ₓCₓO₃, wherein an element A includes at least Pb, an element B includes at least one of Zr, Ti, V, W, and Hf, and an element C includes at least one of Nb and Ta, and
the raw material composition including:
at least one of a thermally-decomposable organometallic compound including the element A, the element B, or the element C, a hydrolyzable organometallic compound including the element A, the element B, or the element C, and a partial hydrolyzate and/or a polycondensate of the hydrolyzable organometallic compound;
at least one of a polycarboxylic acid and a polycarboxylic acid ester; and
an organic solvent.

2. The complex metal oxide raw material composition as defined in claim 1,
wherein the element B includes Zr and Ti; and
wherein the element C includes Nb.

3. The complex metal oxide raw material composition as defined in claim 1 or 2,
wherein the organic solvent is an alcohol.

4. The complex metal oxide raw material composition as defined in any one of claims 1 to 3,
wherein the complex metal oxide includes Nb in a range of 0.05≤x<1.

5. The complex metal oxide raw material composition as defined in claim 4,
wherein the complex metal oxide includes Nb in a range of 0.1≤x≤0.3.

6. The complex metal oxide raw material composition as defined in any one of claims 1 to 5,
wherein the complex metal oxide includes Ta in a range of 0.05≤x<1.

7. The complex metal oxide raw material composition as defined in any one of claims 1 to 6,
wherein the complex metal oxide includes 0.5 mol% or more of Si or Si and Ge.

8. The complex metal oxide raw material composition as defined in claim 7,
wherein the complex metal oxide includes 0.5 to 5 mol% of Si or Si and Ge.

9. The complex metal oxide raw material composition as defined in any one of claims 1 to 8,
wherein the polycarboxylic acid or the polycarboxylic acid ester is a dicarboxylic acid or a dicarboxylic acid ester.

10. The complex metal oxide raw material composition as defined in any one of claims 1 to 9,
wherein the organometallic compound including the element A is a lead carboxylate.

11. The complex metal oxide raw material composition as defined in any one of claims 1 to 10,
wherein the organometallic compound including the element B is a niobium carboxylate.

12. The complex metal oxide raw material composition as defined in any one of claims 1 to 11,
wherein the polycarboxylic acid or the polycarboxylic acid ester has a boiling point higher than the boiling point of the organic solvent.

13. The complex metal oxide raw material composition as defined in any one of claims 1 to 12,
wherein the polycarboxylic acid ester is dimethyl succinate.
